# EUROPEAN PATENT APPLICATION

(11) **EP 4 394 001 A1**
(43) Date of publication of application: **03.07.2024**
(21) Application number: 22890178.1
(22) Date of filing: 21.09.2022
(51) Int. Cl.: C09B 62/00, C09B 57/00, C09B 67/00, C09B 67/22, C09K 11/08, C09K 11/62, C09K 11/64, C09K 11/88, G02B 5/20

(54) **REACTIVE DYE AND PHOTOSENSITIVE COMPOSITION USING SAME**

(30) Priority: 08.11.2021 KR 20210152579
(71) Applicant: Duksan Neolux Co., Ltd, Chungcheongnam-do 31027 (KR)
(72) Inventor: SEO, Hanwook, Cheonan-si Chungcheongnam-do 31027 (KR); LEE, Changmin, Cheonan-si Chungcheongnam-do 31027 (KR); KO, Yun Jong, Cheonan-si Chungcheongnam-do 31027 (KR); LIM, Jaehyun, Cheonan-si Chungcheongnam-do 31027 (KR); CHO, Hyunsang, Cheonan-si Chungcheongnam-do 31027 (KR); PARK, Da Heon, Cheonan-si Chungcheongnam-do 31027 (KR); MUN, Soung Yun, Cheonan-si Chungcheongnam-do 31027 (KR)
(74) Representative: BCKIP Part mbB
(86) International application number: PCT/KR2022/014135
(87) International publication number: WO 2023/080442

(57) **Abstract**

According to an embodiment of the present disclosure, the present disclosure provides a dye with excellent light resistance that is not deformed by external sunlight and excellent chemical resistance that does not change color by other solvents during the process even when molded at low temperatures, a photosensitive resin composition to which such dye is applied, and a display device to which the same is applied.

## Description

### TECHNICAL FIELD

The present disclosure relates to a dye consisting of a novel-structured protective group having a reactive group and a chromophore, a photosensitive composition including the same, and an organic light emitting display device to which the photosensitive composition is applied

### BACKGROUND

As for the flexible OLED display, various structures have been proposed to reduce the curvature thereof, and one of them is a non-polarizing plate OLED display. A polarizer is an essential technology in LCD; however, in OLED, it is used to increase visibility by preventing the light incident from the outside from being reflected inside a panel.

A polarizing plate is a composite film consisting of several layers and is thick, which causes a problem in that it lowers the curvature in the flexible OLED display. Additionally, the polarizing plate absorbs 50% to 60% of the light emitted from the inside of the OLED, causing high power consumption, and since a high current is transferred to the light emitting layer to emit light with higher luminance, it also affects the lifetime.

In order to compensate for these disadvantages, the non-polarizing plate OLED display with the polarizing plate removed has been attracting attention. In order to remove the polarizing plate, various technologies have been proposed, and among them, the most interesting technology is to filter the color of the light reflected from the inside by introducing a color filter on top of the OLED light emitting layer.

However, in the case where the polarizing plate is removed, there is a problem in that the colorant used in the color filter is affected by external sunlight and thus shows optical characteristics different from those at the initial stage, and there is also a problem in that the pattern must be formed at a low temperature in order not to affect the OLED light emitting layer deposited in a lower part during the color filter formation process.

### SUMMARY

In order to solve the problems in the prior art, in an embodiment, the present disclosure provides a dye with excellent light resistance that is not deformed by external sunlight and excellent chemical resistance that does not change color by other solvents during the process even when molded at low temperatures, a photosensitive resin composition to which such dye is applied, and a display device to which the same is applied.

The present disclosure provides a reactive dye which includes a chromophore including a structure represented by Formula (1); and a protecting group including a structure represented by Formula (2) and surrounding the chromophore.

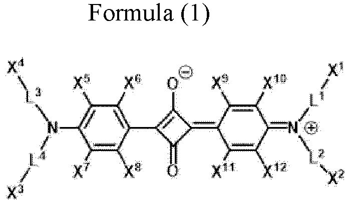

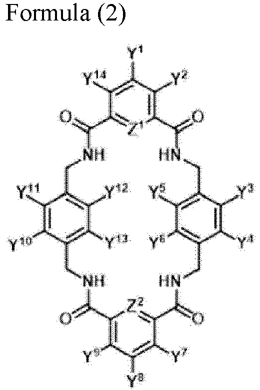

In a specific embodiment, the present disclosure provides a photosensitive composition which includes an alkali-soluble resin; a reactive unsaturated compound; a photoinitiator; the above reactive dye; and a solvent.

The alkali-soluble resin preferably includes a resin including a repeating unit of Formula (3).

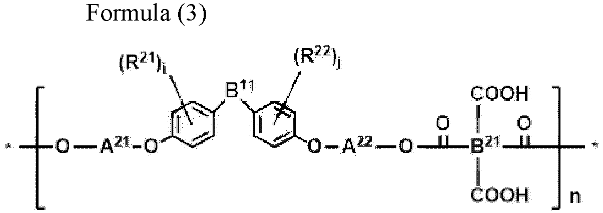

In another specific embodiment, the present disclosure provides a pattern or film formed of the photosensitive resin composition.

In another specific embodiment, the present disclosure provides an organic light emitting display device including the pattern or film.

In another specific embodiment, the present disclosure provides an electronic device including the display device and a control unit operating the display device.

### ADVANTAGEOUS EFFECTS

An object of the present disclosure is to provide a dye with excellent light resistance that is not deformed by external sunlight and excellent chemical resistance that does not change color by other solvents during the process even when molded at low temperatures, a photosensitive resin composition to which such dye is applied, and a display device to which the same is applied.

### BRIEF DESCRIPTION OF THE DRAWINGS

FIG. 1 conceptually illustrates a display device for implementing the present disclosure.
FIGS. 2 and 3 representatively illustrate Formula (1) and Formula (2) according to the present disclosure.

### MODE FOR CARRYING OUT THE INVENTION

The present disclosure provides a reactive dye which includes a chromophore including a structure represented by Formula (1); and a protecting group including a structure represented by Formula (2) and surrounding the chromophore.

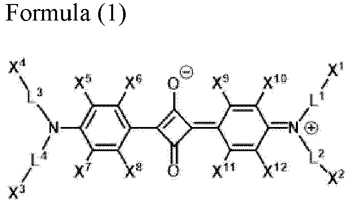

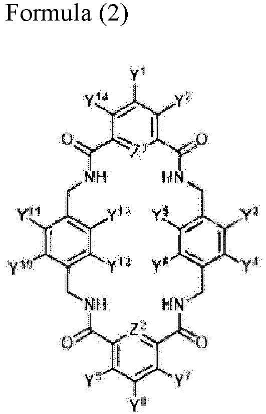

### DETAILED DESCRIPTION

Hereinafter, some embodiments of the present disclosure will be described in detail with reference to exemplary drawings. In adding reference numerals to components of each drawing, the same components may have the same reference numerals even though they are indicated in different drawings.

When it is determined that a detailed description of a related known constitution or function may obscure the gist of the present disclosure in describing the present disclosure, the detailed description thereof may be omitted. When the expressions "includes", "has", "consisting of', *etc.* mentioned in this specification are used, other parts may be added unless "only" is used. When a component is expressed in the singular form, it may include a case in which the plural form is included unless otherwise explicitly stated.

Additionally, in describing the components of the present disclosure, terms such as first, second, A, B, (a), (b), *etc.* may be used. These terms are only for distinguishing the components from other components, and the essence, order, sequence, the number, *etc.* of the components are not limited by the terms.

In the description of the positional relationship of the components, when two or more components are described as being "connected", "linked", or "fused", *etc.,* the two or more components may be directly "connected", "linked", or "fused", but it should be understood that the two or more components may also be "connected", "linked", or "fused" by way of a further "interposition" of a different component. In particular, the different component may be included in any one or more of the two or more components that are to be "connected", "linked", or "fused" to each other.

Additionally, when a component (e.g., a layer, a film, a region, a plate, *etc.)* is described to be "on top" or "on" of another component, it should be understood that this may also include a case where another component is "immediately on top of" as well as a case where another component is disposed therebetween. In contrast, it should be understood that when a component is described to be "immediately on top of" another component, it should be understood that there is no other component disposed therebetween.

In the description of the temporal flow relationship relating to the components, the operation method, or the preparation method, for example, when the temporal precedence or flow precedence is described by way of "after", "subsequently", "thereafter", "before", *etc.,* it may also include cases where the flow is not continuous unless terms such as "immediately" or "directly" are used.

Meanwhile, when the reference is made to numerical values or corresponding information for components, numerical values or corresponding information may be interpreted as including an error range that may occur due to various factors (*e.g.,* procedural factors, internal or external shocks, noise, *etc*.) even if it is it not explicitly stated.

The terms used in this specification and the appended claims are as follows, unless otherwise stated, without departing from the spirit of the present disclosure.

As used herein, the term "halo" or "halogen" includes fluorine (F), chlorine (Cl), bromine (Br), and iodine (I), unless otherwise specified.

As used herein, the term "alkyl" or "alkyl group" refers to a radical of a saturated aliphatic functional group, including a linear chain alkyl group, a branched chain alkyl group, a cycloalkyl (alicyclic) group, an alkyl-substituted cycloalkyl group, and a cycloalkyl-substituted alkyl group, which has 1 to 60 carbons linked by a single bond unless otherwise specified.

As used herein, the term "haloalkyl group" or "halogenalkyl group" refers to an alkyl group in which a halogen is substituted, unless otherwise specified.

As used herein, the term "alkenyl" or "alkynyl" has a double bond or triple bond, respectively, includes a linear or branched chain group, and has 2 to 60 carbon atoms unless otherwise specified, but is not limited thereto.

As used herein, the term "cycloalkyl" refers to an alkyl which forms a ring having 3 to 60 carbon atoms unless otherwise specified, but is not limited thereto.

As used herein, the term "alkoxy group" or "alkyloxy group" refers to an alkyl group to which an oxygen radical is linked, and has 1 to 60 carbon atoms unless otherwise specified, but is not limited thereto.

As used herein, the term "alkenoxyl group", "alkenoxy group", "alkenyloxyl group", or "alkenyloxy group" refers to an alkenyl group to which an oxygen radical is linked, and has 2 to 60 carbon atoms unless otherwise specified, but is not limited thereto.

As used herein, the terms "aryl group" and "arylene group" each have 6 to 60 carbon atoms unless otherwise specified, but are not limited thereto. As used herein, the aryl group or arylene group includes a single ring type, a ring assembly, a fused multiple ring compound, *etc.* For example, the aryl group may include a phenyl group, a monovalent functional group of biphenyl, a monovalent functional group of naphthalene, a fluorenyl group, and a substituted fluorenyl group, and the arylene group may include a fluorenylene group and a substituted fluorenylene group.

As used herein, the term "ring assembly" means that two or more ring systems (monocyclic or fused ring systems) are directly connected to each other through a single bond or double bond, in which the number of direct links between such rings is one less than the total number of ring systems in the compound. In the ring assembly, the same or different ring systems may be directly connected to each other through a single bond or double bond.

As used herein, since the aryl group includes a ring assembly, the aryl group includes biphenyl and terphenyl in which a benzene ring, which is a single aromatic ring, is connected by a single bond. Additionally, since the aryl group also includes a compound in which an aromatic ring system fused to an aromatic single ring is connected by a single bond, it also includes, for example, a compound in which a benzene ring (which is a single aromatic ring) and fluorine (which is a fused aromatic ring system) are linked by a single bond.

As used herein, the term "fused multiple ring system" refers to a fused ring form in which at least two atoms are shared, and it includes a form in which ring systems of two or more hydrocarbons are fused, a form in which at least one heterocyclic system including at least one heteroatom is fused, *etc.* Such a fused multiple ring system may be an aromatic ring, a heteroaromatic ring, an aliphatic ring, or a combination of these rings. For example, in the case of an aryl group, it may be a naphthalenyl group, a phenanthrenyl group, a fluorenyl group, *etc.,* but is not limited thereto.

As used herein, the term "a spiro compound" has a spiro union, and the spiro union refers to a linkage in which two rings share only one atom. In particular, the atom shared by the two rings is called a "spiro atom", and they are each called "monospiro-", "dispiro-", and "trispiro-" compounds depending on the number of spiro atoms included in a compound.

As used herein, the terms "fluorenyl group", "fluorenylene group", and "fluorenetriyl group" refer to a monovalent, divalent, or trivalent functional group in which R, R', R", and R‴ are all hydrogen in the following structures, respectively, unless otherwise specified; "substituted fluorenyl group", "substituted fluorenylene group", or "substituted fluorenetriyl group" means that at least one of the substituents R, R', R", and R‴ is a substituent other than hydrogen, and includes cases where R and R' are bound to each other to form a spiro compound together with the carbon to which they are linked. As used herein, all of the fluorenyl group, the fluorenylene group, and the fluorenetriyl group may also be referred to as a fluorene group regardless of valences such as monovalent, divalent, trivalent, *etc.*

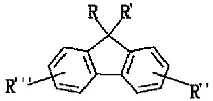

Additionally, the R, R', R", and R‴ may each independently be an alkyl group having 1 to 20 carbon atoms, an alkenyl group having 1 to 20 carbon atoms, an aryl group having 6 to 30 carbon atoms, and a heterocyclic group having 2 to 30 carbon atoms and, for example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or divalent functional group of 9,9-dimethylfluorene, 9,9-diphenylfluorene, and 9,9'-spirobi[9H-fluorene].

As used herein, the term "heterocyclic group" includes not only aromatic rings (e.g., "heteroaryl group" and "heteroarylene group"), but also non-aromatic rings, and may refer to a ring having 2 to 60 carbon atoms each including one or more heteroatoms unless otherwise specified, but is not limited thereto. As used herein, the term "heteroatom" refers to N, O, S, P, or Si unless otherwise specified, and a heterocyclic group refers to a monocyclic group including a heteroatom, a ring assembly, a fused multiple ring system, a spiro compound, *etc.*

For example, the "heterocyclic group" may include a compound including a heteroatom group (*e.g.,* SO₂, P=O, *etc*.)*,* such as the compound shown below, instead of carbon that forms a ring.

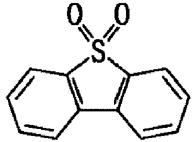

As used herein, the term "ring" includes monocyclic and polycyclic rings, and includes heterocycles containing at least one heteroatom as well as hydrocarbon rings, and includes aromatic and non-aromatic rings.

As used herein, the term "polycyclic" includes ring assemblies (*e*.*g*., biphenyl, terphenyl, *etc*.), fused multiple ring systems, and spiro compounds, includes non-aromatic as well as aromatic compounds, and includes heterocycles containing at least one heteroatom as well as hydrocarbon rings.

As used herein, the term "alicyclic group" refers to cyclic hydrocarbons other than aromatic hydrocarbons, and it includes monocyclic, ring assemblies, fused multiple ring systems, spiro compounds, *etc.,* and refers to a ring having 3 to 60 carbon atoms unless otherwise specified, but is not limited thereto. For example, when benzene (*i.e.,* an aromatic ring) and cyclohexane (*i.e.,* a non-aromatic ring) are fused, it also corresponds to an aliphatic ring.

Additionally, when prefixes are named consecutively, it means that the substituents are listed in the order they are described. For example, in the case of an arylalkoxy group, it means an alkoxy group substituted with an aryl group; in the case of an alkoxycarbonyl group, it means a carbonyl group substituted with an alkoxy group; additionally, in the case of an arylcarbonyl alkenyl group, it means an alkenyl group substituted with an arylcarbonyl group, in which the arylcarbonyl group is a carbonyl group substituted with an aryl group.

Additionally, unless otherwise specified, the term "substituted" in the expression "substituted or unsubstituted" as used herein refers to a substitution with one or more substituents selected from the group consisting of deuterium, a halogen, an amino group, a nitrile group, a nitro group, a C₁₋₃₀ alkyl group, a C₁-₃₀ alkoxy group, a C₁-₃₀ alkylamine group, a C₁-₃₀ alkylthiophene group, a C₆-₃₀ arylthiophene group, a C₂-₃₀ alkenyl group, a C₂-₃₀ alkynyl group, a C₃-₃₀ cycloalkyl group, a C₆-₃₀ aryl group, a C₆-₃₀ aryl group substituted with deuterium, a C₈-₃₀ arylalkenyl group, a silane group, a boron group, a germanium group, and a C₂₋₃₀ heterocyclic group containing one or more heteroatoms selected from the group consisting of O, N, S, Si, and P, but is not limited to these substituents.

As used herein, the "names of functional groups" corresponding to the aryl group, arylene group, heterocyclic group, *etc.* exemplified as examples of each symbol and a substituent thereof may be described as "a name of the functional group reflecting its valence", and may also be described as the "name of its parent compound". For example, in the case of "phenanthrene", which is a type of an aryl group, the names of the groups may be described such that the monovalent group is described as "phenanthryl (group)", and the divalent group is described as "phenanthrylene (group)", *etc.,* but may also be described as "phenanthrene", which is the name of its parent compound, regardless of its valence.

Similarly, in the case of pyrimidine as well, it may be described regardless of its valence, or in the case of being monovalent, it may be described as pyrimidinyl (group); and in the case of being divalent, it may be described as the "name of the group" of the valence (e.g., pyrimidinylene (group)). Therefore, as used herein, when the type of a substituent is described as the name of its parent compound, it may refer to an n-valent "group" formed by detachment of a hydrogen atom linked to a carbon atom and/or hetero atom of its parent compound.

Additionally, in describing the names of the compounds or the substituents in the present specification, the numbers, letters, *etc.* indicating positions may be omitted. For example, pyrido[4,3-d]pyrimidine may be described as pyridopyrimidine; benzofuro[2,3-d]pyrimidine as benzofuropyrimidine; 9,9-dimethyl-9H-fluorene as dimethyl fluorene, *etc.* Therefore, both benzo[g]quinoxaline and benzo[f]quinoxaline may be described as benzoquinoxaline.

Additionally, unless there is an explicit description, the formulas used in the present disclosure are applied in the same manner as in the definition of substituents by the exponent definition of the formula below.

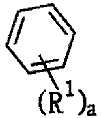

In particular, when a is an integer of 0, it means that the substituent R¹ is absent, that is, when a is 0, it means that hydrogens are linked to all carbons that form a benzene ring, and in this case, the formula or compound may be described while omitting the indication of the hydrogen linked to the carbon. Additionally, when a is an integer of 1, one substituent R¹ may be linked to any one of the carbons forming a benzene ring; when a is an integer of 2 or 3, it may be linked, for example, as shown below; even when a is an integer of 4 to 6, it may be linked to the carbon of a benzene ring in a similar manner; and when a is an integer of 2 or greater, R¹ may be the same as or different from each other.

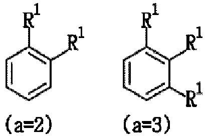

Unless otherwise specified in the present application, forming a ring means that neighboring groups bind to one another to form a single ring or fused multiple ring, and the single ring and the formed fused multiple ring include a heterocycle containing at least one heteroatom as well as a hydrocarbon ring, and may include aromatic and non-aromatic rings.

Additionally, unless otherwise specified in the present specification, when indicating a condensed ring, the number in "number-condensed ring" indicates the number of rings to be condensed. For example, a form in which three rings are condensed with one another (e.g., anthracene, phenanthrene, benzoquinazoline, etc.) may be expressed as a 3-condensed ring.

Meanwhile, as used herein, the term "bridged bicyclic compound" refers to a compound in which two rings share 3 or more atoms to form a ring, unless otherwise specified. In particular, the shared atoms may include carbon or a hetero atom.

In the present disclosure, an organic electric device may refer to a component(s) between a positive electrode and a negative electrode, or may refer to an organic light emitting diode which includes a positive electrode, a negative electrode, and a component(s) disposed therebetween.

Additionally, in some cases, the display device in the present disclosure may refer to an organic electric device, an organic light emitting diode, and a panel including the same, or may refer to an electronic device including a panel and a circuit. In particular, for example, the electronic device may include a lighting device, a solar cell, a portable or mobile terminal (e.g., a smart phone, a tablet, a PDA, an electronic dictionary, a PMP, *etc*.), a navigation terminal, a game machine, various TV sets, various computer monitors, *etc.,* but is not limited thereto, and may be any type of device as long as it includes the component(s).

Hereinafter, embodiments of the present disclosure will be described in detail. However, these embodiments are provided for illustrative purposes, and the present disclosure is not limited thereby, and the present disclosure is only defined by the scope of the claims to be described later.

The photosensitive resin composition according to an embodiment of the present disclosure includes a reactive dye, an alkali-soluble resin, a reactive unsaturated compound, a photoinitiator, and a solvent, and may further include a colorant in additional to the above components.

Hereinafter, each component will be described in detail.

### (1) Reactive dye

The reactive dye according to an embodiment of the present disclosure is a chromophore-protecting group dye, and it includes a chromophore including a structure represented by Formula (1) below and a protecting group surrounding the chromophore and including a structure represented by Formula (2) below.

A reactive dye, which includes:
a chromophore including a structure represented by Formula (1); and a protecting group including a structure represented by Formula (2) and surrounding the chromophore; 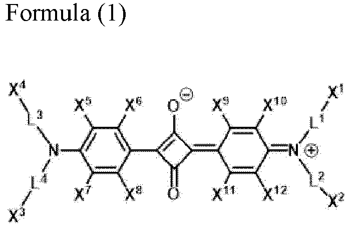
wherein in Formula (1) above,
   1) L¹ to L⁴ are each independently a single bond; a fluorenylene group; C₁₋₃₀ alkylene; a C₃₋₃₀ cycloalkylene group; a C₁₋₃₀ alkoxylene group, a C₂₋₃₀ polyethyleneoxy group; a C₆₋₃₀ arylene group; a C₂₋₃₀ heterocyclic ring; or a combination thereof,
   2) X¹ to X⁴ are each independently hydrogen; deuterium; a fluorenyl group; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or Formula (A),
   3) at least one of X¹ to X⁴ is Formula (A), 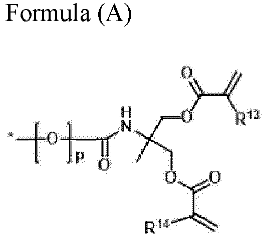 in Formula (A) above,
      3-1) * is a moiety bonded to L¹ to L⁴ or N,
      3-2) p is an integer from 0 to 1,
      3-3) when Formula (A) is directly bonded to N, p is 0,
      3-4) R¹³ and R¹⁴ are independently hydrogen or a methyl group,
   4) X⁵ to X¹² are each independently hydrogen; deuterium; a fluorenyl group; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or a C₁-₃₀ alkylamine group,
   5) X⁵ to X¹² may be able to bind to each other to form a ring, 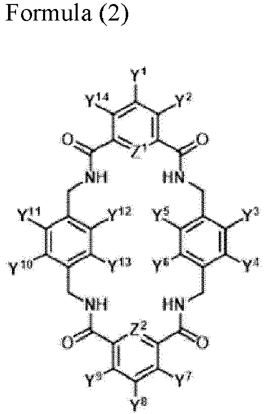 wherein in Formula (2) above,
   6) Z¹ and Z² are each independently a carbon atom or a nitrogen atom,
   7) Y¹ to Y¹⁴ are each independently hydrogen; deuterium; halogen; a fluorenyl group; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or a C₁-₃₀ alkylamine group,
   8) Y¹ to Y¹⁴ may bind to each other to form a ring,
   9) the X¹ to X¹⁴, Y¹ to X¹⁴, and L¹ to L⁴ may each be further substituted with one or more substituents selected from the group consisting of deuterium; halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group including at least one heteroatom among O, N, S, Si, and P; a C₃₋₃₀ alicyclic group; a C₇₋₃₀ arylalkyl group; a C₈₋₃₀ arylalkenyl group; and a combination thereof; or may form a ring between the neighboring substituents.

In the structure represented by Formula (1), when L¹ to L⁴ are polyethyleneoxy groups, the polyethyleneoxy group is preferably any group selected from the group consisting of a monoethyleneoxy group, a diethyleneoxy group, a triethyleneoxy group, a tetraethyleneoxy group, a pentaethyleneoxy groups, a hexaethyleneoxy group, a heptaethyleneoxy group, an octaethyleneoxy group, a nonaethyleneoxy group, a decaethyleneoxy group, an undecaethyleneoxy group, a dodecaethyleneoxy group, a tridecaethyleneoxy group, a tetradecaethyleneoxy group, and a pentadecaethyleneoxy group.

In the structure represented by Formula (1), at least one of X¹ and X² is Formula (A), and at least one of X³ and X⁴ is preferably Formula (A). More specifically, among the X¹ to X⁴, the remainder where Formula (A) is not substituted are preferably each independently selected from the group consisting of an aryl group, an alkyl group, and a cycloalkyl group, and more preferably an aryl group. Most preferably, the aryl group is preferably substituted with an alkyl group. The chromophore-protecting dye of the present disclosure represented by the above structure can secure excellent light resistance.

The chromophore-protecting group dye according to an embodiment is preferable because chemical resistance of the photosensitive composition including the chromophore-protecting group can be secured by introducing a bifunctional acrylate group to both ends of the squalene dye. More specifically, compatibility and coloring power with other components of the photosensitive composition (i.e., an alkali-soluble resin and a reactive unsaturated compound described later) may be secured, and precipitation of the chromophore-protecting dye may be prevented. That is, in the case of the chromophore-protecting group dye of the present disclosure, it has excellent light resistance and chemical resistance and exhibits properties suitable for red or green dyes of color filters.

In the chromophore-protecting group dye, the chromophore including the structure represented by Formula (1) has three resonance structures as shown in Scheme 1 below, but in the present specification, only one resonance structure is shown for convenience purposes. That is, the chromophore including the structure represented by Formula (1) may be represented by one of the following three resonance structures.

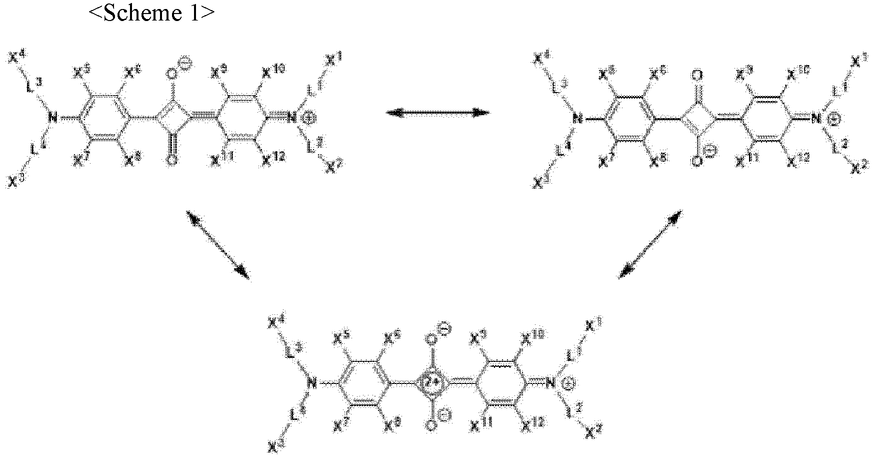

The chromophore including the structure represented by Formula (1) may have a maximum absorption peak at a wavelength of 520 nm to 680 nm. A photosensitive composition for a color filter having high luminance and excellent light resistance can be obtained by way of using the chromophore-protecting dye containing the chromophore having the spectral characteristics as a green or red dye.

A chromophore-protecting group dye according to an embodiment of the present disclosure has a structure consisting of a chromophore and a protecting group surrounding the chromophore. The protecting group includes a structure represented by Formula (2). Specifically, the protecting group may be a macrocyclic compound, and the protecting group may form a coating layer while surrounding a chromophore having a structure represented by Formula (1).

In an embodiment, the protecting group corresponding to the macrocyclic compound has a structure surrounding a chromophore including the structure represented by Formula (1), that is, by having a structure in which the compound represented by Formula (1) exists inside the macrocycle, the durability of the chromophore-protecting dye can be improved, and accordingly, a color filter having excellent light resistance and chemical resistance can be implemented.

The cage width of the protecting group including the structure represented by Formula (2) may be 6.5 Å to 7.5 Å, and the volume of the protecting group may be 10 Å to 16 Å. In the present specification, the cage width is the inner length of the protecting group, and refers to the distance between the number 1 phenylene group and the number 2 phenylene group in the following Scheme 2 (see Scheme 2). When the protecting group has a cage width within the above range, a chromophore-protecting group dye having a structure surrounding a chromophore including the structure represented by Formula (1) can be obtained, and accordingly, when the chromophore-protecting group dye is added to the photosensitive composition is added, a color filter having excellent durability and high luminance can be implemented.

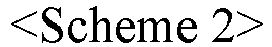

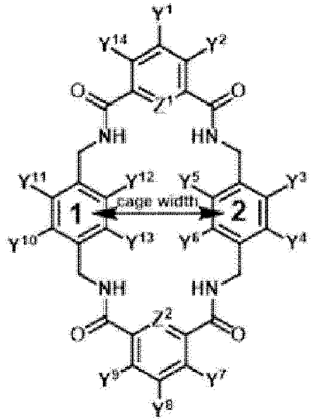

The chromophore-protecting group dye may include a chromophore having a structure represented by Formula (1) and a protecting group having a structure represented by Formula (2) in a 1:1 molar ratio. When the chromophore and the protecting group are present in the above molar ratio, a coating layer (a protecting group) surrounding the chromophore may be well formed. The form, in which the protecting group including the structure represented by Formula (2) surrounds the chromophore including the structure represented by Formula (1), is as shown in Scheme 3 below, in which the rod-shaped chromophore is in a form of penetrating the ringshaped protecting group.

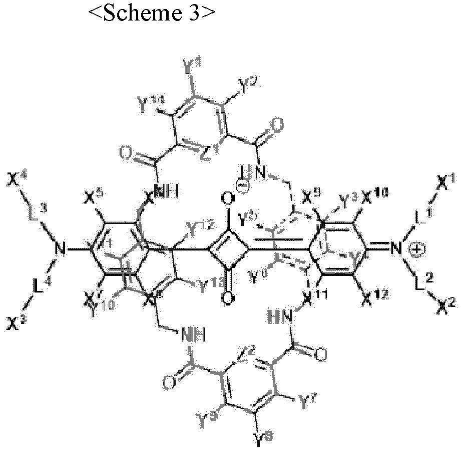

The chromophore-protecting group dye may be used alone as a red or green dye or may be used in combination with a toning dye, a quantum dot, or a pigment.

Examples of the toning dye may include triarylmethane-based dyes, anthraquinone-based dyes, benzylidene-based dyes, cyanine-based dyes, phthalocyanine-based dyes, azapophyrin-based dyes, indigo-based dyes, xanthene-based dyes, pyridone-azo-based dyes, *etc.*

The photosensitive composition may include 0.1 wt% to 50 wt% of the chromophore-protecting dye based on the solid content excluding a solvent. For example, the chromophore-protecting dye may be included in an amount of 0.1 wt% to 40 wt%, and preferably 0.5 wt% to 30 wt%. When the chromophore-protecting group dye is used within the above range, high luminance and contrast ratio can be expressed in a desired color coordinate.

### (2) Quantum dots

Additionally, the chromophore-protecting group dye may be used in combination with quantum dots.

A quantum dot may have a core/shell structure consisting of a multilayer structure including a core and a shell surrounding the core. Additionally, a quantum dot may have a core/multishell structure having two or more shells. For example, a quantum dot may have a core/shell/shell structure having a core and a double shell.

The core and the shell of the quantum dot may consist of a group II-VI compound, a group II-V compound, a group III-V compound, a group III-IV compound, a group III-VI compound, a group IV-VI compound, or a mixture thereof, and a dopant may be doped or alloyed in the core or shell of the quantum dot, and a compound constituting the core and a compound constituting the shell may be different from each other.

The core may include one or more ternary compounds selected from InZnN, InZnP, InZnAs, InZnSb, InZnBi, GaZnN, GaZnP, GaZnAs, GaZnSb, GaZnBi, AlZnN, AlZnP, AlZnAs, AlZnSb, and AlZnTi.

Additionally, the core may include one or more quaternary element compounds selected from InGaZnN, InGaZnP, InGaZnAs, InGaZnSb, InGaZnBi, InAlZnN, InAlZnP, InAlZnAs, InAlZnSb, InAlZnBi, GaAlZnN, GaAlZnP, GaAlZnAs, GaAlZnSb, and GaAlZnBi.

The shell may be one or more selected from CdS, CdSe, CdTe, ZnS, ZnSe, ZnTe, ZnSeS, PbS, PbSe, PbSeS, PbTe, GaAs, GaP, InP, InGaP, InZnP, InAs, CuS, InN, GaN, InGaN, AlP, AlAs, InAs, GaAs, GaSb, InSb, AlSb, HgS, HgTe, HgCdTe, ZnCdS, ZnCdSe, CdSeTe, CuInSe₂, CuInS₂, AgInS₂, and SnTe.

The core/shell or core/multishell may further include a cluster molecule as a seed. The cluster molecule is a compound that serves as a seed in the process of preparing the core/shell or core/multishell, and as the precursors of the compound constituting the core/shell or core/multishell grow on the cluster molecule, the core/shell or core/multishell may be formed.

The quantum dot may have a single layer rather than a multilayer structure (a core/shell structure) and may be consisting of, for example, only a II-VI compound.

The particle size of the quantum dots is preferably in the range of 1 nm to 30 nm, and most preferably 5 nm to 15 nm.

Additionally, the quantum dots may further include a ligand. For example, an amine compound, a thiol compound, or a carboxylic acid compound having a C₁₋₃₀ alkyl group or C₂₋₃₀ alkenyl group, C₂₋₃₀ (poly)ethyleneoxy group, or C₆₋₃₀ aryl group may be included as a ligand. Examples of the amine compound having an alkyl group include hexadecylamine, octylamine, *etc.*

Other examples of the ligand may include phosphine compounds including trioctylphosphine, triphenolphosphine, *t*-butylphosphine, *etc*.; phosphine oxides such as trioctylphosphine oxide, *etc*.; pyridine, thiophene, *etc.*

The type of the ligand is not limited to those exemplified above.

The ligands of the core-shell-ligand complex can prevent core/shell or core/multishells neighboring to one another from being aggregated and quenched. The ligand binds to the core/shell or core/multishells and may have a hydrophobic property.

When the chromophore-protecting dye and the quantum dots are mixed and used, they may be mixed at a weight ratio of 1:9 to 9: 1, and specifically, 3:7 to 7:3. When the chromophore-protecting dye and the quantum dots are mixed within the range of the above weight ratio, it is possible to have high luminance and contrast ratio while maintaining color characteristics.

### (3) Colorant

Additionally, the chromophore-protecting group dye may be used in combination with a pigment.

The pigment includes a red pigment, a green pigment, a blue pigment, a yellow pigment, a black pigment, *etc.*

Examples of the red pigment include C.I. Pigment Red 254, C.I. Pigment Red 255, C.I. Pigment Red 264, C.I. Pigment Red 270, C.I. Pigment Red 272, C.I. Pigment Red 177, C.I. Pigment Red 89, *etc.*

Examples of the green pigment include C.I. Pigment Green 7, C.I. Pigment Green 36, C.I. Pigment Green 58, C.I. Pigment Green 59, *etc.*

Examples of the blue pigment include copper phthalocyanine pigments such as C.I. Pigment Blue 15:6, C.I. Pigment Blue 15, C.I. Pigment Blue 15:1, C.I. Pigment Blue 15:2, C.I. Pigment Blue 15:3, C.I. Pigment Blue 15:4, C.I. Pigment Blue 15:5, C.I., and Pigment Blue 16, *etc.*

Examples of the yellow pigment include isoindoline-based pigments such as C.I. Pigment Yellow 139, *etc.;* quinophthalone-based pigments such as C.I. Pigment Yellow 138; C.I. nickel complex pigments such as Pigment Yellow 150, *etc.*

Examples of the black pigment include aniline black, perylene black, titanium black, carbon black, *etc.*

The pigments may be used alone or in combination of two or more, but are not limited to these examples.

The pigment may be included in a photosensitive composition in the form of a dispersion. Such pigment dispersion may consist of the pigments, a dispersion solvent, a dispersant, a dispersion resin, *etc.*

As the dispersing solvent, ethylene glycol acetate, ethyl cellosolve, propylene glycol methyl ether acetate, ethyl lactate, polyethylene glycol, cyclohexanone, propylene glycol methyl ether, *etc.* may be used, and among these, propylene glycol methyl ether acetate may preferably be used.

The dispersant helps to uniformly disperse the pigments in the dispersion, and all nonionic, anionic, and cationic dispersants may be used. Specifically, polyalkylene glycol or an ester thereof, polyoxyalkylene, a polyhydric alcohol ester alkylene oxide adduct, an alcohol alkylene oxide adduct, a sulfonic acid ester, a sulfonic acid salt, a carboxylic acid ester, a carboxylic acid salt, an alkyl amide alkylene oxide adduct, alkyl amine, *etc.* may be used, and these may be used alone or in combination of two or more.

As the dispersion resin, an acryl-based resin including a carboxyl group may be used, which may improve the stability of the pigment dispersion and improve the resolution of the pattern during the color filter formation process.

When the chromophore-protecting group dye and the pigment are mixed and used, these may be mixed in a weight ratio of 1:9 to 9: 1, and specifically, 3:7 to 7:3. Additionally, when the chromophore-protecting group dye and the toning dye are mixed and used, these may be mixed in a weight ratio of 1:9 to 9: 1, and specifically, 3:7 to 7:3, and when these are mixed in the above weight ratio range, the resultant can have high luminance and contrast ratio while maintaining color characteristics.

The photosensitive composition may include 0.1 wt% to 50 wt% of the sum of the chromophore-protecting dye and the colorant based on the solid content excluding the solvent. For example, it may be included in an amount of 0.1 wt% to 40 wt%, and preferably 0.5 wt% to 30 wt%. When the chromophore-protecting dye and the colorant are used within the above range, high luminance and contrast ratio can be expressed in a desired color coordinate.

### (4) Alkali-soluble resin

The photosensitive resin composition according to an embodiment of the present disclosure includes a resin, which includes a repeating unit represented by the following Formula (3) as an alkali-soluble resin.

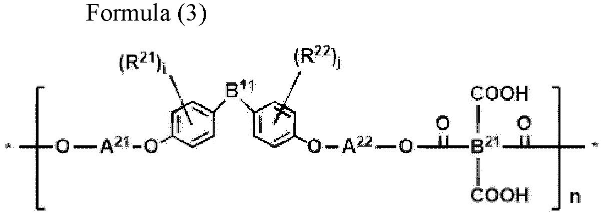

In the above Formula (3),
1) * indicates a moiety where a bond is connected as a repeating unit,
2) n is a repeating unit of 2 to 200,000,
3) R²¹ and R²² are each independently hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; a fluorenyl group; a carbonyl group; an ether group; or a C₁-₃₀ alkoxycarbonyl group,
4) R²¹ and R²² may each form a ring with neighboring groups,
5) i and j are each independently an integer from 0 to 4,
6) B¹¹ is a single bond, O, CO, SO₂, CR'R", SiR'R", Formula (D), or Formula (E),
   6-1) R' and R" are each independently hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁-₃₀ alkoxycarbonyl group,
   6-2) R' and R" may each be able to form a ring with neighboring groups, and embodiments in which R' or R" forms a ring by binding are as follows: 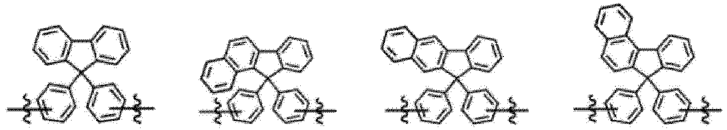 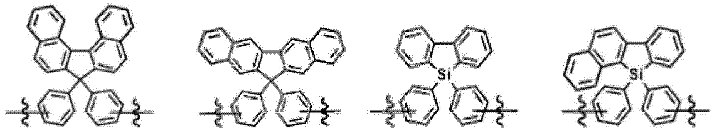 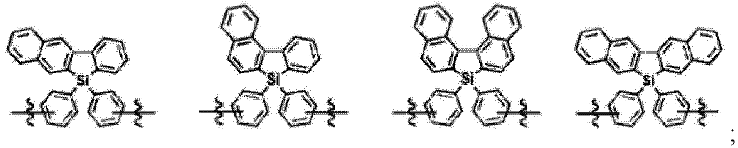 and specifically, Formula (D) and Formula (E) are as shown below: 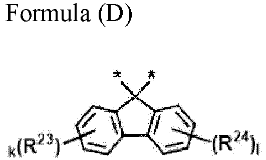 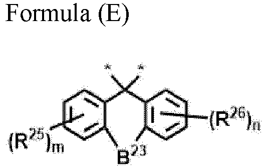 wherein in Formula (D) and Formula (E) above,
      6-3) * indicates a binding position,
      6-4) B²³ is O, S, SO₂, or NR',
      6-5) R' is hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁-₃₀ alkoxycarbonyl group,
      6-6) R²³ to R²⁶ are each independently hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁-₃₀ alkoxycarbonyl group,
      6-7) R²³ to R²⁶ may each form a ring with neighboring groups,
      6-8) k to n are each independently an integer from 0 to 4,
7) B²¹ is a fluorenyl group; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; or a combination thereof,
8) A²¹ and A²² are each independently Formula (F) or Formula (G), 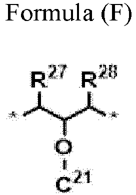 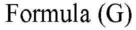 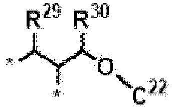 wherein in Formula (F) and Formula (G) above,
   8-1) * indicates a binding position,
   8-2) R²⁷ to R³⁰ are each independently hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁-₃₀ alkoxycarbonyl group,
   8-3) C²¹ and C²² are each independently Formula (H), 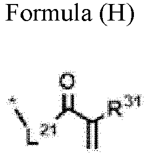
      8-3-1) * indicates a binding position,
      8-3-2) R³¹ is hydrogen; deuterium; halogen; a C₆₋₃₀ aryl group; a C₂₋₃₀ heterocyclic group including at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a fluorenyl group; a carbonyl group; an ether group; or a C₁₋₃₀ alkoxycarbonyl group,
      8-3-3) L²¹ is a single bond; a fluorenylene group; C₁₋₃₀ alkylene; a C₆₋₃₀ arylene group; a C₂₋₃₀ heterocyclic ring; or C₁-₃₀ alkoxylene,
   8-4) the ratio of Formula (F) to Formula (G) in the resin including the repeating unit represented by Formula (3) is 1:9 to 9:1,
9) the R²¹ to R³¹, R', R", B²¹, and L²¹ and the ring formed between the neighboring substituents may each be further substituted with one or more substituents selected from the group consisting of deuterium; halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group including at least one heteroatom among O, N, S, Si, and P; a C₃₋₃₀ alicyclic group; a C₇₋₃₀ arylalkyl group; a C₈₋₃₀ arylalkenyl group; and a combination thereof; or may form a ring between the neighboring substituents.

When R²¹ to R³¹, R' and R"are aryl groups, these may preferably be a C₆-₃₀ aryl group, more preferably a C₆-₁₈ aryl group, for example, phenyl, biphenyl, naphthyl, terphenyl, *etc.*

Where R²¹ to R³¹, R', R", B²¹, and L²¹ are heterocyclic groups, these may preferably be a C₂-₃₀ heterocyclic group, and more preferably a C₂-₁₈ heterocyclic group, for example, dibenzofuran, dibenzothiophene, naphthobenzothiophene, naphthobenzofuran, *etc.*

When R²¹ to R³¹, R', and R" are fluorenyl groups, these may preferably be 9,9-dimethyl-9H-fluorene, a 9,9-diphenyl-9H-fluorenyl group, 9,9'-spirobifluorene, *etc.*

When B²¹ and L²¹ are arylene groups, these may preferably be a C₆-₃₀ arylene group, and more preferably a C₆-₁₈ arylene groups, for example, phenyl, biphenyl, naphthyl, terphenyl, *etc.*

When R²¹ to R³¹, R', and R" are alkyl groups, these may preferably be a C₁-₁₀ alkyl group, for example, methyl, *t*-butyl, *etc.*

When R²¹ to R³¹, R', and R" are alkoxyl groups, these may preferably be a C₁-₂₀ alkoxyl group, and more preferably a C₁-₁₀ alkoxyl group, for example, methoxy, *t*-butoxy, *etc.*

The rings formed by the bonding among the neighboring groups of R²¹ to R³¹, R', R", B²¹, and L²¹ to one another may be a C₆-₆₀ aromatic ring group; a fluorenyl group; a C₂₋₆₀ heterocyclic group including at least one heteroatom among O, N, S, Si, and P; or a C₃-₆₀ alicyclic group, for example, when the neighboring groups bind with one another to form an aromatic ring; preferably, a C₆-₂₀ aromatic ring, more preferably a C₆-₁₄ aromatic ring, for example, benzene, naphthalene, phenanthrene, *etc.* may be formed.

The ratio of the structure represented by Formula (F) to the structure represented by Formula (G) in the polymer chain of the resin including the repeating unit represented by Formula (3) is preferably 1:9 to 9:1, and most preferably, it is a ratio of 8:2 to 2:8. In the case of a resin in which the structure represented by Formula (F) and the structure represented by the Formula (G) are mixed in the polymer chain in the same ratio as above, the compatibility with other components in the photosensitive composition is improved, and thus, during the pattern formation, the generation of residues is less and the resolution is excellent compared to when using a resin including only the structure represented by Formula (F) or a resin including only the structure represented by Formula (G).

The resin including the repeating unit represented by Formula (3) may have a weight average molecular weight of 1,000 g/mol to 100,000 g/mol, preferably 1,000 g/mol to 50,000 g/mol, and more preferably 1,000 g/mol to 30,000 g/mol. When the weight average molecular weight of the resin is within the above range, a pattern can be well formed without residues during the preparation of a pattern layer, there is no loss of film thickness during development, and a good pattern can be obtained.

The resin including the repeating unit represented by Formula (3) may be included in an amount of 1 wt% to 50 wt%, and more preferably 5 wt% to 45 wt%, based on the total amount of the photosensitive composition. When the resin is included within the above range, excellent sensitivity, developability, and adhesion (cohesion) can be obtained.

The photosensitive composition may further include an acryl-based resin in addition to the resin including the repeating unit represented by Formula (3). The acryl-based resin is a copolymer of a first ethylenically unsaturated monomer and a second ethylenically unsaturated monomer copolymerizable therewith, and it includes one or more acryl-based repeating units. The acryl-based resin may be a copolymer of ethylenically unsaturated monomers including 2 to 10 types of acrylates, methacrylates, styrene, maleimide, maleic acid, maleic anhydride, *etc.,* and may have a weight average molecular weight of 5,000 g/mol to 30,000 g/mol.

The sum of the resin containing the repeating unit represented by Formula (3) and the acryl-based resin may be included in an amount of 1 wt% to 50 wt%, and more preferably 5 wt% to 45 wt% based on the total amount of the photosensitive composition. When the sum of the resin including the repeating unit represented by Formula (3) and the acryl-based resin is within the above range, excellent sensitivity, developability, and adhesion (cohesion) can be obtained.

### (5) Reactive unsaturated compounds

The photosensitive resin composition according to an embodiment of the present disclosure includes a reactive unsaturated compound that can be crosslinked by a radical in the step of light exposure.

Since the reactive unsaturated compound has an ethylenically unsaturated double bond, it is possible to form a pattern having excellent heat resistance, light resistance, and chemical resistance by causing sufficient polymerization during exposure to light in the pattern forming process.

Specific examples of the reactive unsaturated compound may be ethylene glycol diacrylate, ethylene glycol dimethacrylate, diethylene glycol diacrylate, triethylene glycol diacrylate, triethylene glycol dimethacrylate, 1,6-hexanediol diacrylate, 1,6-hexanediol dimethacrylate, pentaerythritol triacrylate, dipentaerythritol pentaacrylate, dipentaerythritol hexaacrylate, bisphenol A epoxy acrylate, ethylene glycol monomethyl ether acrylate, trimethylolpropane triacrylate, tripentaerythritol octaacrylate, *etc.*

Examples of commercially available products of the reactive unsaturated compound are as follows.

Examples of the bifunctional ester of (meth)acrylic acid may include Aronix M-210, M-240, M-6200, *etc.* (Toa Kosei Kagaku Kogyo Co., Ltd.), KAYARAD HDDA, HX-220, R-604, *etc.* (Nippon Kayaku Co., Ltd.), and V-260, V-312, V-335 HP, *etc.* (Osaka Yuki Kagaku Kogyo Co., Ltd.).

Examples of the trifunctional ester of (meth)acrylic acid include M-309, M-400, M-405, M-450, M-7100, M-8030, M-8060, *etc.* (Toa Kosei Kagaku Kogyo Co., Ltd.), KAYARAD TMPTA, DPCA-20, DPCA-60, DPCA-120, *etc.* (Nippon Kayaku Co., Ltd.), and V-295, V-300, V-360, *etc.* (Osaka Yuki Kagaku Kogyo Co., Ltd.).

These products may be used alone or in combination of two or more.

The reactive unsaturated compound may be used after treating with an acid anhydride so as to provide improved developability. The reactive unsaturated compound may be included in an amount of 1 wt% to 50 wt%, for example, 5 wt% to 30 wt%, based on the total amount of the photosensitive composition. When the reactive unsaturated compound is included within the above range, sufficient curing occurs during exposure to light in the pattern forming process, thus obtaining excellent reliability, excellent heat resistance, light resistance, and chemical resistance of the pattern, and also excellent resolution and adhesion.

### (6) Photoinitiator

The photosensitive composition according to an embodiment of the present disclosure may include the following photoinitiator, and as the photoinitiator, an oxime ester-based compound may be used alone or in combination of two or more.

The photoinitiator that can be used in combination with the oxime ester-based compound is a photoinitiator used in a photosensitive composition, for example, an acetophenone-based compound, a benzophenone-based compound, a thioxanthone-based compound, a benzoin-based compound, a triazine-based compound, *etc.* may be used.

Examples of the oxime ester-based compound may include2-(o-benzoyloxime)-1-[4-(phenylthio)phenyl]-1,2-octanedione, 1-(o-acetyloxime)-1-[9-ethyl-6-(2-methylbenzoyl) -9H-carbazol-3-yl]ethanone, O-ethoxycarbonyl-a-oxyamino-1-phenylpropan-1-one, 2-dimethylamino-2-(4-methylbenzyl)-1-(4-morpholin-4-yl-phenyl)-butan-1-one, 1-(4-phenylsulfanylphenyl)-butane-1,2-dione2-oxime-*O*-benzoate, 1-(4-phenylsulfanylphenyl)-octan-1,2-dione2-oxime-*O*-benzoate, 1-(4-phenylsulfanylphenyl)- octan-1-one oxime-*O*-acetate and 1-(4-phenylsulfanylphenyl)-butan-1-one oxime-*O*-acetate, 1-(4-methylsulfanyl-phenyl)-butan-1-one oxime-*O*-acetate, hydroxyimino-(4-methylsulfanyl-phenyl)-acetate ethyl ester-*O*-acetate, hydroxyimino-(4-methylsulfanyl-phenyl)-acetate ethyl ester-O-benzoate, *etc.*

Examples of the acetophenone-based compound may include 2,2'-diethoxy acetophenone, 2,2'-dibutoxy acetophenone, 2-hydroxy-2-methylpropiophenone, *p*-*t*-butyltrichloro acetophenone, *p*-*t*-butyldichloro acetophenone, 4-chloro acetophenone, 2,2'-dichloro-4-phenoxy acetophenone, 2-methyl-1-(4-(methylthio)phenyl)-2-morpholinopropan-1-one, 2-benzyl-2-dimethylamino-1-(4-morpholinophenyl)-butan-1-one, *etc.*

Examples of the benzophenone-based compound may include benzophenone, benzoyl benzoate, methyl benzoyl benzoate, 4-phenyl benzophenone, hydroxy benzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, 3,3'-dimethyl-2-methoxybenzophenone, *etc.*

Examples of the thioxanthone-based compound may include thioxanthone, 2-chlorthioxanthone, 2-methylthioxanthone, isopropyl thioxanthone, 2,4-diethyl thioxanthone, 2,4-diisopropyl thioxanthone, 2-chlorothioxanthone, *etc.*

Examples of the benzoin-based compound may include benzoin, benzoin methyl ether, benzoin ethyl ether, benzoin isopropyl ether, benzoin isobutyl ether, benzyldimethyl ketal, *etc.*

Examples of the triazine-based compound may include 2,4,6-trichloro-*s*-triazine, 2-phenyl 4,6-*bis*(trichloromethyl)-s-triazine, 2-(3',4'-dimethoxystyryl)-4,6-*bis*(trichloromethyl)-s-triazine, 2-(4'-methoxynaphthyl)-4, 6-*bis*(trichloromethyl)-s-triazine, 2-(*p*-methoxyphenyl)-4,6-*bis*(trichloromethyl)-s-triazine, 2-(*p*-tolyl)-4,6-bis(trichloromethyl)-s-triazine; 2-biphenyl 4,6-*bis*(trichloromethyl)-s-triazine, *bis*(trichloromethyl)-6-styryl-s-triazine, 2-(naphthol-yl)-4,6-*bis*(trichloromethyl)-s-triazine, 2-(4-methoxynaphthol-yl)-4,6-*bis*(trichloromethyl)-s-triazine, 2-4-trichloromethyl(piperonyl)-6-triazine, 2-4-trichloromethyl(4'-methoxystyryl)-6-triazine, *etc.*

As the photoinitiator, a carbazole-based compound, a diketone-based compound, a sulfonium borate-based compound, a diazo-based compound, an imidazole-based compound, a non-imidazole-based compound, *etc.* may be used in addition to the compounds described above.

As the photoinitiator, which is a radical polymerization initiator, a peroxide-based compound, an azobis-based compound, *etc.* may be used.

Examples of the peroxide-based compound may include ketone peroxides (*e.g.,* methyl ethyl ketone peroxide, methyl isobutyl ketone peroxide, cyclohexanone peroxide, methylcyclohexanone peroxide, acetylacetone peroxide, *etc*.); diacyl peroxides (*e.g.,* isobutyryl peroxide, 2,4-dichlorobenzoyl peroxide, *o*-methylbenzoyl peroxide, *bis*-3,5,5-trimethylhexanoyl peroxide, *etc*.); hydroperoxides (*e*.*g*., 2,4,4,-trimethylpentyl-2-hydroperoxide, diisopropylbenzene hydroperoxide, cumene hydroperoxide, *t*-butyl hydroperoxide, *etc*.); dialkyl peroxides (*e.g.,* dicumyl peroxide, 2,5-dimethyl-2,5-di(*t*-butylperoxy)hexane, 1,3*-bis*(*t-*butyloxyisopropyl)benzene, *t*-butylperoxyvalerate n-butyl ester, *etc.);* alkyl peresters (*e.g.,* 2,4,4-trimethylpentyl peroxyphenoxyacetate, α-cumyl peroxyneodecanoate, *t*-butyl peroxybenzoate, di*t*-butyl peroxytrimethyl adipate, *etc*.); percarbonates (*e*.*g*., di-3-methoxybutyl peroxydicarbonate, di-2-ethylhexyl peroxydicarbonate, *bis*-4-t-butylcyclohexyl peroxydicarbonate, diisopropyl peroxydicarbonate, acetylcyclohexylsulfonyl peroxide, *t*-butyl peroxyaryl carbonate, *etc*.)*, etc.*

Examples of the azobis-based compound may include 1,1'-azobiscyclohexan-1-carbonitrile, 2,2'-azobis(2,4-dimethylvaleronitrile), 2,2,-azobis(methylisobutyrate), 2,2'-azobis(4-methoxy-2,4-dimethylvaleronitrile), α,α'-azobis(isobutylnitrile), 4,4'-azobis(4-cyanovaleric acid), *etc.*

The photoinitiator may be used together with a photosensitizer that causes a chemical reaction by absorbing light to enter an excited state and then transferring the energy. Examples of the photosensitizer may include tetraethylene glycol bis-3-mercaptopropionate, pentaerythritol tetrakis-3-mercaptopropionate, dipentaerythritol tetrakis-3-mercaptopropionate, *etc.*

The photoinitiator may be included in an amount of 0.01 wt% to 10 wt%, for example, 0.1 wt% to 5 wt%, based on the total amount of the photosensitive resin composition. When the photoinitiator is included within the above range, it is possible to obtain excellent reliability due to sufficient curing that occurs during exposure to light in the pattern forming process, thereby obtaining excellent heat resistance, light resistance, and chemical resistance of the pattern, and also obtaining excellent resolution and adhesion, and being capable of preventing a decrease in transmittance due to an unreacted initiator.

### (7) Solvent

As the solvent, materials may be used which are compatible with the alkali-soluble resin, the reactive unsaturated compound, the reactive dye, the colorant, and the initiator but do not react with these.

Examples of the solvent include alcohols (*e.g.,* methanol, ethanol, *etc.);* ethers *(e.g.,* dichloroethyl ether, n-butyl ether, diisoamyl ether, methylphenyl ether, tetrahydrofuran, *etc*.); glycol ethers (*e.g.,* ethylene glycol monomethyl ether, ethylene glycol monoethyl ether, *etc.);* cellosolve acetates (*e.g.,* methyl cellosolve acetate, ethyl cellosolve acetate, diethyl cellosolve acetate, *etc.);* carbitols (*e.g.,* methylethyl carbitol, diethyl carbitol, diethylene glycol monomethyl ether, diethylene glycol monoethyl ether, diethylene glycol dimethyl ether, diethylene glycol methyl ethyl ether, diethylene glycol diethyl ether, *etc.);* propylene glycol alkyl ether acetates (*e.g.,* propylene glycol methyl ether acetate, propylene glycol propyl ether acetate, *etc*.); aromatic hydrocarbons (*e.g.,* toluene, xylene, *etc.);* ketones (*e.g.,* methyl ethyl ketone, cyclohexanone, 4-hydroxy-4-methyl-2-pentanone, methyl-*n*-propyl ketone, methyl-*n*-butyl ketone, methyl-*n*-amyl ketone, 2-heptanone, *etc*.); saturated aliphatic monocarboxylic acid alkyl esters (*e.g.,* ethyl acetate, *n*-butyl acetate, isobutyl acetate, *etc.);* lactic acid esters (*e.g.,* methyl lactate and ethyl lactate); oxyacetic acid alkyl esters (*e.g.,* methyloxyacetate, ethyloxyacetate, butyl oxyacetate, *etc.*); alkoxy acetate alkyl esters (*e.g.,* methoxy methyl acetate, methoxy ethyl acetate, methoxy butyl acetate, ethoxy methyl acetate, ethoxy ethyl acetate, *etc*.); 3-oxypropionic acid alkyl esters (*e.g.,* 3-oxy methyl propionate, 3-oxy ethyl propionate, *etc*.); 3-alkoxy propionic acid alkyl esters (*e.g., 3-*methoxy methyl propionate, 3-methoxy ethyl propionate, 3-ethoxy ethyl propionate, 3-ethoxy methyl propionate, *etc*.); 2-oxypropionic acid alkyl esters (*e.g.,* methyl 2-oxypropionate, ethyl 2-oxypropionate, propyl 2-oxypropionate, *etc*.); 2-alkoxy propionic acid alkyl esters (*e.g., 2-*methoxy methyl propionate, 2-methoxy ethyl propionate, 2-ethoxy ethyl propionate, 2-ethoxy methyl propionate, *etc*.); 2-oxy-2-methyl propionic acid esters (*e.g.,* 2-oxy-2-methyl methyl propionate, 2-oxy-2-methyl ethyl propionate, *etc*.); monooxy monocarboxylic acid alkyl esters of 2-alkoxy-2-methyl propionic acid alkyls (*e.g.,* 2-methoxy-2-methyl methyl propionate, 2-ethoxy-2-methyl ethyl propionate, *etc.);* esters (*e.g.,* 2-hydroxyethyl propionate, 2-hydroxy-2-methyl ethyl propionate, ethyl hydroxyacetate, 2-hydroxy-3-methyl methyl butanoate, *etc*.); ketonic acid esters (*e.g.,* ethyl pyruvate, *etc*.)*, etc.*

Further, high boiling point solvents such as *N*-methylformamide, *N*,*N*-dimethylformamide, *N*-methylformanilad, N-methylacetamide, *N*,*N*-dimethylacetamide, *N*-methylpyrrolidone, dimethyl sulfoxide, benzylethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and phenyl cellosolve acetate may also be used.

Among the solvents above, considering compatibility and reactivity, the following solvents may be used: glycol ethers (*e.g.,* ethylene glycol monoethyl ether, *etc*.); ethylene glycol alkyl ether acetates (*e.g.,* ethyl cellosolve acetate, *etc*.); esters (*e*.*g.,* ethyl 2-hydroxypropionate, *etc.);* carbitols (*e.g.,* diethylene glycol monomethyl ether, *etc*.); and propylene glycol alkyl ether acetates (*e.g.,* propylene glycol methyl ether acetate, propylene glycol propyl ether acetate, *etc*.).

The solvent may be included as a balance based on the total amount of the photosensitive resin composition, and specifically in the amount of 50 wt% to 90 wt%. When the solvent is included within the above range, the photosensitive resin composition has an appropriate viscosity, and thus the processability becomes excellent in preparing the pattern layer.

### (8) Other additives

In order to prevent stains or spots during application, to improve leveling performance, and to prevent the generation of undeveloped residues, the photosensitive composition may further include other additives such as malonic acid; 3-amino-1,2-propanediol; a silane-based coupling agent including a vinyl group or (meth)acryloxy group; a leveling agent; a fluorine-based surfactant; and a radical polymerization initiator.

Additionally, the photosensitive composition may further include an additive such as an epoxy compound so as to improve adhesion with a substrate.

Examples of the epoxy compound may include a phenol novolac epoxy compound, a tetramethyl biphenyl epoxy compound, a bisphenol A type epoxy compound, an alicyclic epoxy compound, or a combination thereof.

The content of the additives can easily be adjusted according to desired physical properties.

Still another embodiment of the present disclosure may provide a color filter prepared using the photosensitive composition described above. A method of preparing the color filter is as follows.

### <Color filter formation process>

On a glass substrate on which nothing is coated, or on a glass substrate on which a protective film, SiNx, is applied in a thickness of 500 Å to 1500 Å, the above-described photosensitive resin composition is applied using an appropriate method (*e*.*g*., spin coating, slit coating, *etc*.) to form a thickness of 3.1 µm to 3.4 µm, respectively. After the application, light is irradiated to form a pattern required for a color filter. After the light irradiation, when the coating layer is treated with an alkaline developing solution, the non-irradiated portion of the coating layer is dissolved and a pattern required for the color filter is formed. By repeating this process according to the required number of R, G, and B colors, a color filter having a desired pattern can be obtained. In the above process, crack resistance, solvent resistance, *etc.* can be further improved by heating again the image pattern obtained by development or curing by irradiation with actinic rays, *etc.*

Still another embodiment of the present disclosure may provide an organic light emitting display device.

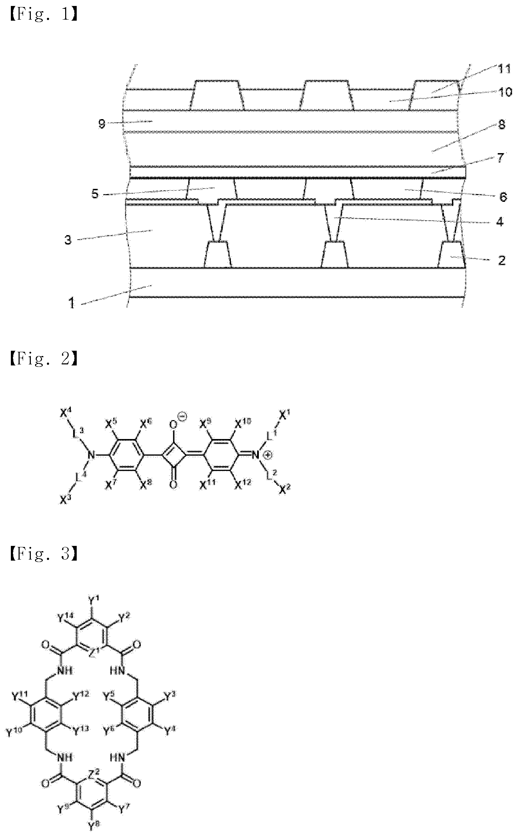

Hereinafter, an organic light emitting display device will be described referring to FIG. 1. The organic light emitting display device according to an embodiment of the present disclosure is characterized in that it includes a substrate (1), a TFT layer (2) on the substrate, a flattening layer (3) on the TFT layer, an organic light emitting device layer on the flattening layer, a sealing layer (8) disposed on the organic light emitting device layer, a touch panel (9) disposed on the sealing layer, and a color filter disposed on the touch panel, in which the color filter include a pattern or film formed of the photosensitive composition of the present disclosure.

The pattern or film is formed of a photosensitive composition including, as essential component, the chromophore-protecting group dye, which includes a chromophore including the structure represented Formula (1) above and a protecting group including the structure represented by Formula (2) above.

The substrate (1) may be a flexible substrate. The substrate may be made of a plastic material having excellent heat resistance and durability, such as such polyimide (PI), polyethylene terephthalate (PET), polyethylene naphtalate (PEN), polycarbonate (PC), polyarylate (PAR), polyetherimide (PEI), and polyethersulfone (PES). However, the present disclosure is not limited thereto, and various flexible materials (e.g., metal foil or thin glass) may be used. Meanwhile, the substrate may be a rigid a substrate, and in particular, the substrate may be made of a glass material containing SiO₂ as a main component.

In the case of a bottom emission type in which the image is implemented in the direction of a substrate, the substrate must be formed of a transparent material. However, in the case of a top emission type in which the image is implemented in the opposite direction of a substrate, the substrate does not necessarily have to be formed of a transparent material. In this case, the substrate may be formed of a metal. When the substrate is formed of a metal, the substrate may include one or more selected from the group consisting of carbon, iron, chromium, manganese, nickel, titanium, molybdenum, and stainless steel (SUS), but is not limited thereto.

A TFT layer (2) may be disposed on the substrate. As used herein, the term TFT layer collectively refers to a thin film transistor (TFT) array for operating an organic light emitting device, and it refers to a driving part for displaying an image. FIG. 1 shows only an organic light emitting device and a driving thin film transistor for driving the organic light emitting device, which are only for convenience of description and the present disclosure is not limited to what is shown, and it is apparent to those skilled in the art that a plurality of thin film transistors, storage capacitors, and various wirings may be further included.

The TFT layer may be protected by being covered with a flattening layer (3). The flattening layer may include an inorganic insulating layer and/or an organic insulating layer. Examples of the inorganic insulating film that can be used for the flattening layer may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), zirconium oxide (ZrO₂), barium strontium titanate (BST), lead zirconate-titanate (PZT), *etc.*

Additionally, examples of the organic insulating film that can be used for the flattening layer may include common general-purpose polymers (PMMA, PS), polymer derivatives having phenolic groups, acryl-based polymers, imide-based polymers, arylether-based polymers, amide-based polymers, fluorine-based polymers, p-xylene-based polymers, vinyl alcohol-based polymers, and blends thereof.

Meanwhile, the flattening layer may have a composite stacked structure of an inorganic insulating film and an organic insulating film.

An organic light emitting device layer may be formed on the upper part of the flattening layer. The organic light emitting device layer may include a pixel electrode (4) formed on the flattening layer, a counter electrode (7) disposed to face the pixel electrode, and an organic material layer (6) interposed therebetween. When a voltage is applied between the pixel electrode and the counter electrode, the organic material layer can emit light. The organic material layer may emit red light, green light, blue light, white light, *etc.* The organic light emitting display device may further include blue, green, and red color filters so as to express color images when the organic material layer emits white light, and so as to increase color purity and light efficiency when the organic material layer emits red light, green light, and blue light.

The organic light emitting display device may be classified into a bottom emission type, a top emission type, a dual emission type, *etc.* according to the emission direction. In an organic light emitting display device of the bottom emission type, the pixel electrode is provided as a light transmitting electrode and the counter electrode is provided as a reflective electrode. In an organic light emitting display device of the top emission type, the pixel electrode is provided as a reflective electrode and the counter electrode is provided as a semi-transmissive electrode. In the present disclosure, the top emission type, in which the organic light emitting device emits light in the direction of a sealing layer, will be described.

The pixel electrode may be a reflective electrode. The pixel electrode may include a stacked structure of a reflective layer and a transparent or semi-transparent electrode layer having a high work function. The reflective layer may include Ag, Mg, Al, Pt, Pd, Au, Ni, Nd, Ir, Cr, or an alloy thereof. The transparent or semi-transparent electrode layer may include at least one material selected from among transparent conductive oxide materials, such as indium tin oxide (ITO), indium zinc oxide (IZO), zinc oxide (ZnO), indium oxide (In₂O₃; indium oxide), indium gallium oxide (IGO), aluminum zinc oxide (AZO), *etc.* The pixel electrode may be formed by patterning in an island shape corresponding to each pixel. Additionally, the pixel electrode may function as an anode electrode.

Meanwhile, a pixel defining layer (5) may be disposed on the pixel electrode so as to cover the edge of the pixel electrode and include a predetermined opening part that exposes the central part of the pixel electrode. An organic material layer including an organic light emitting layer that emits light may be disposed on the area limited by the opening part. The region on which an organic material layer is disposed may be defined as a light emitting region.

Meanwhile, when the light emitting region is formed within the opening part of the pixel defining layer, a region protruding by the pixel defining layer is disposed between the light emitting regions, and this region may be defined as a non-light emitting area because an organic light emitting layer is not formed in this protruding area.

The counter electrode may be formed as a transmissive electrode. The counter electrode may be a semi-transmissive layer in which a metal having a small work function (*e.g.,* Li, Ca, LiF/Ca, LiF/Al, Al, Mg, Ag, *etc*.) is thinly formed. In order to compensate for the high resistance problem of the thin metal semi-transmissive layer, a transparent conductive layer made of a transparent conductive oxide may be stacked on the metal semi-transmissive layer. The counter electrode may be formed over the entire surface of a substrate in the form of a common electrode. Additionally, such a counter electrode may function as a cathode electrode.

The polarities of the pixel electrode and the counter electrode as described above may be opposite to each other.

The organic material layer includes an organic light emitting layer that emits light, and the organic light emitting layer may use a low molecular weight organic material or high molecular weight organic material. When the organic light emitting layer is a low molecular-weight organic layer formed of a low molecular organic material, a hole transport layer (HTL), a hole injection layer (HIL), *etc.* may be disposed in the direction of the pixel electrode around the organic light emitting layer, whereas an electron transport layer (ETL), an electron injection layer (EIL), *etc.* may be disposed in the direction of a counter electrode. Certainly, functional layers other than the hole injection layer, hole transport layer, electron transport layer, and electron injection layer may be stacked.

A sealing layer (8) may be disposed on the organic light emitting device layer so as to cover the organic light emitting device layer. The organic light emitting device included in the organic light emitting device layer is composed of an organic material and thus can easily be deteriorated by external moisture or oxygen. Therefore, in order to protect the organic light emitting device, the organic light emitting device layer must be sealed. The sealing layer is a means for sealing the organic light emitting device layer, and may have a structure in which a plurality of inorganic layers and a plurality of organic layers are alternately stacked.

As for the organic light emitting display device according to this embodiment, it is preferable to form a sealing layer with a thin film in which a plurality of inorganic films and a plurality of organic films are alternately stacked instead of a sealing substrate, and flexibility and thinning of the organic light emitting display device can easily be realized by using a thin film as a sealing means.

The sealing layer may include a plurality of inorganic layers and a plurality of organic layers. The inorganic layers and the organic layers may be alternately stacked on each other.

The inorganic layers may be formed of a metal oxide, a metal nitride, a metal carbide, or a combination thereof. For example, the inorganic layers may be made of aluminum oxide, silicon oxide, or silicon nitride. According to another embodiment, the inorganic layers may include a stacked structure of a plurality of inorganic insulating layers. The inorganic layers may perform the functions of preventing the penetration of external moisture and/or oxygen, *etc.* into the organic light emitting device layer.

The organic layers may be high molecular weight organic compounds. For example, the organic layers may include any one of epoxy, acrylate, and urethane acrylate. The organic layers may perform the functions of relieving internal stress of the inorganic layers or compensating for defects and flattening the inorganic layers.

The order of stacking the inorganic and organic layers constituting the sealing layer is not limited. An organic or inorganic layer may be stacked on the organic light emitting device layer, and the uppermost layer of the sealing layer may be an organic or inorganic layer.

A touch panel (9) may be formed on the sealing layer. The touch panel may include a first touch electrode formed on the sealing layer, a second touch electrode disposed to face the first touch electrode, and an insulating layer interposed therebetween.

The first touch electrode and the second touch electrode may be formed in a grid pattern or specific pattern shape. The first touch electrode may be formed to be in contact with an upper part of the sealing layer, and an inorganic layer may be additionally provided between the sealing layer and the first touch electrode.

The first touch electrode and the second touch electrode may be formed of ITO (Indium Tin Oxide) or of a metal mesh and may preferably be formed of a metal mesh.

The metal mesh is an electrode prepared by printing an opaque metal (copper, silver, gold, aluminum, *etc*.) in the form of a grid with a thickness of 1 µm to 7 µm. Due to the use of a metal with high conductivity, the metal mesh has the advantages in that it has a low resistance value thus having a fast touch response speed, enables easy realization of a large screen, and is cheaper than ITO film in cost. In addition, the metal mesh electrode has excellent durability against repeated bending compared to the ITO electrode, thus being suitable for use as a touch panel electrode for a foldable display.

The touch panel is preferably a capacitive type touch panel that detects the position by recognizing the part where the amount of current has changed and calculating the size using the capacitance of the human body when the user touches the touch panel.

It should be apparent to those skilled in the art that the organic light emitting display device of the present disclosure is not limited to those illustrated, and Control IC (which converts the analog signal transmitted from the touch panel into a digital signal and controls the coordinate values, *etc.* needed to determine the coordinates of the touch area), optical clear adhesive, a flexible printed circuit board (FPCB), in which conductive and signal line patterns are formed to thereby transmit various signals to electronic components, *etc.,* and other various kinds of electronic components and various kinds of wirings may be further included.

A color filter may be formed on the touch panel. The color filter may be prepared in advance and provided in an organic light emitting display device, or a process of forming the color filter directly on a touch panel may be performed.

The color filter may be positioned on an upper part of the touch panel, and it may include a color unit (10), which is aligned in a vertical direction with reference to the light emitting area of the organic light emitting device layer; and a color separation unit (11), which is vertically aligned with the non-emission area and separates the color unit.

The photosensitive composition of the present disclosure may be included in the color separation unit and narrow the wavelength range of the light emitted from the light emitting region, thereby improving the color purity of the organic light emitting display device.

Additionally, the photosensitive composition of the present disclosure may be included in the color separation unit and absorb and block external light incident to the organic light emitting display device thereby improving outdoor visibility.

The photosensitive composition of the present disclosure may include the chromophore-protecting group dye alone or may include the chromophore-protecting group dye together with a red dye or a red pigment to thereby form a red color portion vertically aligned with a red light emitting region.

The photosensitive composition of the present disclosure may include the chromophore-protecting group dye alone or may include the chromophore-protecting group dye together with a green dye or a green pigment to thereby form a green color portion vertically aligned with a green light emitting region.

The photosensitive composition of the present disclosure may include the chromophore-protecting group dye alone or may include the chromophore-protecting group dye together with a blue dye or a blue pigment to thereby form a blue color portion vertically aligned with a blue light emitting region.

The photosensitive composition of the present disclosure may include the chromophore-protecting group dye alone or may include the chromophore-protecting group dye together with a black dye or a black pigment to thereby form a black color portion vertically aligned with a black light emitting region, in which as the black pigment, carbon black is preferred.

In the case of forming a color part of a color filter, particularly a red color part or green color part, using the photosensitive composition of the present disclosure, the resulting color purity is excellent and light resistance to sunlight is also improved, and thus is very preferable. Additionally, when the color separation part of the color filter is formed using the photosensitive composition of the present disclosure, not only light resistance to sunlight can be secured, but also chemical resistance essential to the solution process can be secured, and thus is very preferable.

Additionally, the photocuring of the photosensitive composition of the present disclosure sufficiently proceeds in the process of exposure to light during the photo-patterning process and the post-baking treatment process proceeds at 100°C or lower; therefore, the color filter forming process can be performed without causing heat damage to the organic layer of the organic light emitting device layer.

The position of each layer in the structure of the above-described organic light emitting display device is not limited, and it is apparent to those skilled in the art that several functional layers having specific purposes and functions may be further disposed between each layer, and the organic light emitting display device of the present disclosure is not limited to the structure and drawings described above.

Hereinafter, synthesis examples and examples according to the present disclosure will be described in detail, but the synthesis examples and examples of the present disclosure are not limited thereto.

### Synthesis of a chromophore-a protecting group dye (Squarylium dye)

### Synthesis Example 1 (Synthesis of Squaryllium dye 1)

### Synthesis Example 1-1

100 g of 2,4,6-trimethyl-N-phenylaniline (473.3 mmol, Alchem Company), 86 g of 6-bromo-1-hexanol (475 mmol, TCI Company), 11.5 g of sodium hydride (479.2 mmol, Sigma Aldrich) and 500 g of *N*,*N*-dimethyl formamide were added to a 1,000 mL reactor equipped with a reflux apparatus, the temperature was raised to 80°C, and the mixture was stirred for 18 hours. After the reaction, extraction was performed using 500 mL of diethyl ether (Sigma Aldrich) and 1,000 mL of water, distilled under reduced pressure and separated by column chromatography to obtain 130 g of an intermediate product such as Compound D-1 below.

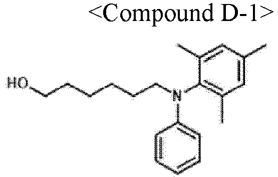

### Synthesis Example 1-2

125 g (401.3 mmol) of Compound D-1, 23 g (201.6 mmol, Sigma AldrichSigma Aldrich) of 3,4-dihydroxy-3-cyclobutene-1,2-dione (Sigma AldrichSigma Aldrich) and 800 g of chlorobenzene were added to a 2,000 mL reactor equipped with a reflux apparatus and Dean-Stark apparatus, the temperature was raised to 120°C, and the mixture was stirred for 18 hours. After completion of the reaction, the solvent was distilled under reduced pressure and separated by column chromatography to obtain 90 g of an intermediate product such as Compound D-2 below.

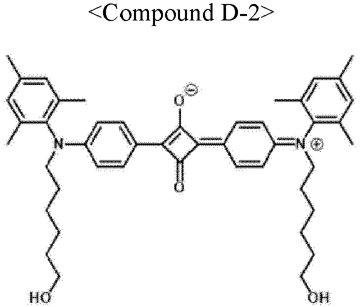

### Synthesis Example 1-3

70g (99.9 mmol) of Compound D-2, 48 g (200.7 mmol) of Karenz BEI (Showa Denko Co.), and 400 g of chloroform (Sigma Aldrich) were added to a 1,000 mL reactor equipped with a reflux apparatus, the temperature was raised to 40°C, and stirred for 18 hours to obtain an intermediate product such as Compound D-3. Then, after cooling the resultant to room temperature, 61 g 300.5 mmol) of isophthloyl chloride (Sigma Aldrich) and 41 g (301.1 mmol) of p-xylylenediamine (Sigma Aldrich) were added dropwise for 3 hours and stirred for 18 hours. After completion of the reaction, the solvent was distilled under reduced pressure and separated by column chromatography to obtain 80 g of squarylium dye 1 below.

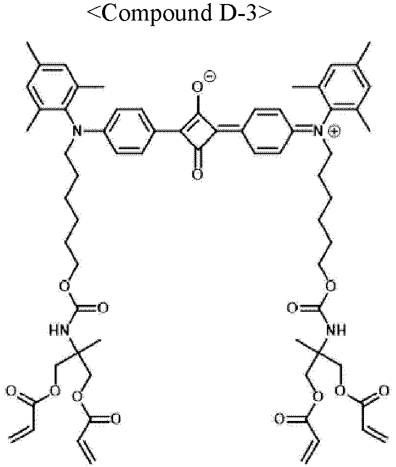

### <Squarylium dye 1>

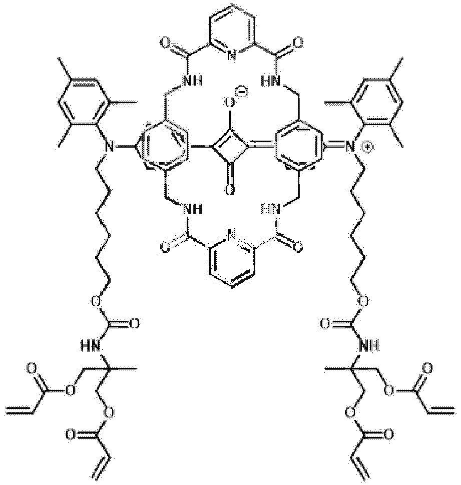

### Synthesis Example 2 (Synthesis of Squaryllium dye 2)

### Synthesis Example 2-1

The synthesis was performed in the same manner as in Synthesis Example 1-1 except for adding 98 g (473.2 mmol,) of (4-(bromomethyl)cyclohexyl)methanol (Chemenu) instead of 86 g (475 mmol) of 6-bromo-1-hexanol (TCI). Through this, 135 g of an intermediate product such as Compound E-1 was obtained.

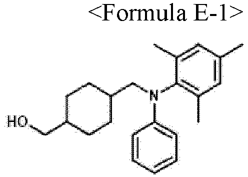

### Synthesis Example 2-2

Synthesis was performed in the same manner as in Synthesis Example 1-2, except that 135 g (400 mmol) of Compound E-1 was used instead of 125 g (401.3 mmol) of Compound D-1 in Synthesis Example 1-2. Through this, it was possible to obtain 120 g of an intermediate such as Compound E-2.

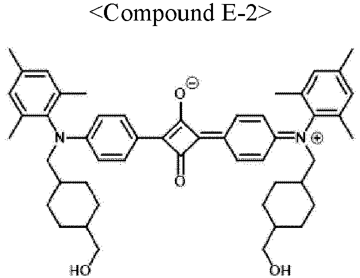

### Synthesis Example 2-3

Synthesis was performed in the same manner as in Synthesis Example 1-3, except for using 75 g (99.6 mmol) of Compound E-2 instead of 70 g (99.9 mmol) of Compound D-2. Through this, it was possible to obtain 100 g of squarylium dye 2.

### <Squarylium dye 2>

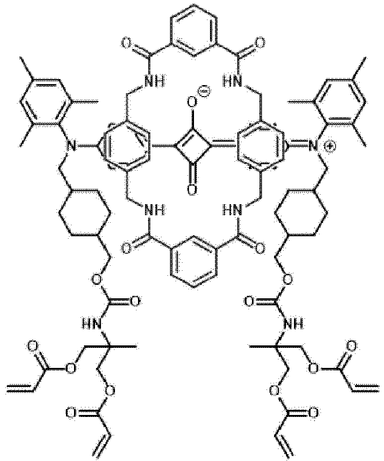

### Synthesis Example 3 (Synthesis of Squaryllium dye 3)

### Synthesis Example 3-1

Synthesis was performed in the same manner as in Synthesis Example 1-1, except for using 95 g (472.5 mmol) of 4-(bromomethyl)benzyl alcohol (Apollo Scientific Co.) instead of 86 g (475 mmol) of 6-bromo-1-hexanol (TCI Co.) in Synthesis Example 1-1.. Through this, it was possible to obtain 140 g of an intermediate product such as Compound F-1.

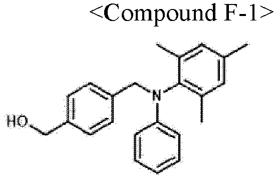

### Synthesis Example 3-2

Synthesis was performed in the same manner as in Synthesis Example 1-2 except for using 133 g (401.3 mmol) of Compound F-1 instead of 125 g (401.3 mmol) of Compound D-1. Through this, it was possible to obtain 125 g of an intermediate jproduct such as Compound F-2.

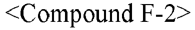

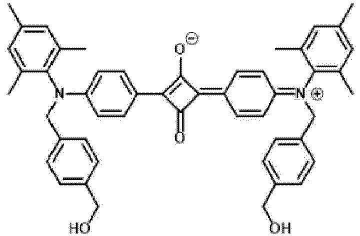

### Synthesis Example 3-3

Synthesis was performed in the same manner as in Synthesis Example 1-3 except for using 74 g (99.9 mmol) of Compound F-2 was used instead of 70 g (99.9 mmol) of Compound D-2. Through this, it was possible to obtain 105 g of squarylium dye 3.

### <Squarylium dye 3>

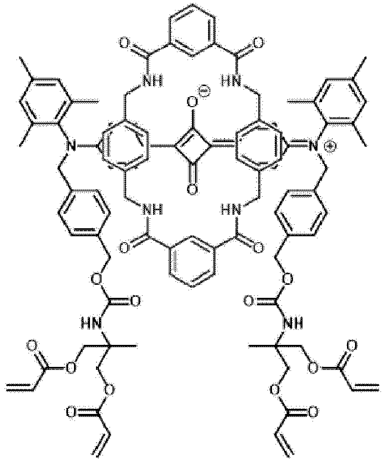

### Synthesis Example 4 (Synthesis of Squaryllium dye 4)

Synthesis was performed in the same manner as in Synthesis Example 1-3 except for using 61 g (299 mmol) of 2,6-pyridinedicarbonyl dichloride (Sigma Aldrich) instead of 61 g (300.5 mmol) of isophthaloyl chloride (Sigma Aldrich). Through this, it was possible to obtain 110 g of squarylium dye 4.

### <Squarylium dye 4>

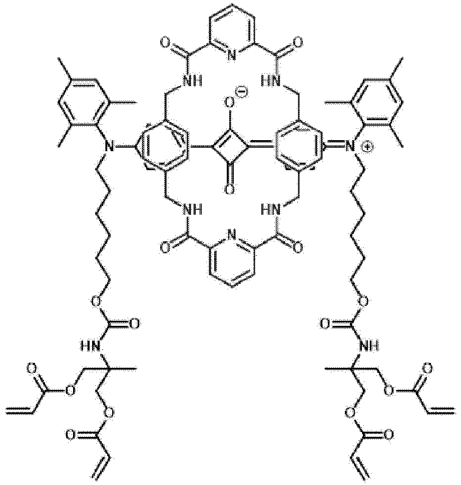

### Synthesis Example 5 (Synthesis of Squaryllium dye 5)

### Synthesis Example 5-1

Synthesis was performed in the same manner as in Synthesis Example 1-1 except for using 114 g (476.5 mmol) of Karenz BEI (Showa Denko Co.) instead of 86 g (475 mmol) of 6-bromo-1-hexanol (TCI Co.). Through this, it was possible to obtain 190 g of an intermediate product such as Compound H-1.

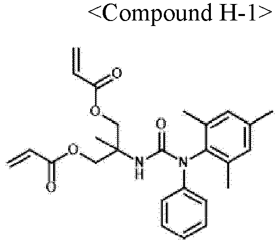

### Synthesis Example 5-2

Synthesis was performed in the same manner as in Synthesis Example 1-2 except for using 180g (399.5 mmol) of Compound H-1 instead of 125 g (401.3 mmol) of Compound D-1 prepared in Synthesis Example 5-1. Through this, it was possible to obtain 170 g of an intermediate product such as Compound H-2.

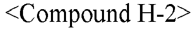

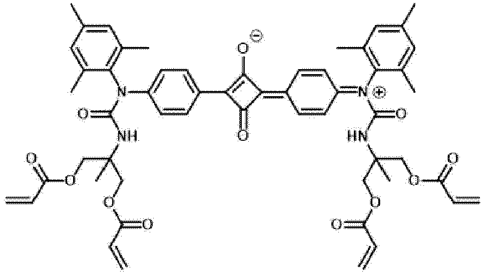

### Synthesis Example 5-3

97g (99.1 mmol) of Compound H-2 and 300 g of chloroform (Sigma Aldrich) were added to a 1,000 mL reactor equipped with a reflux machine, and 61 g (300.5 mmol) of isophthaloyl chloride (Sigma Aldrich) and 41 g (301.1 mmol) of *p*-xylylenediamine (Sigma Aldrich) were added at room temperature dropwise over 3 hours, and stirred for 18 hours. After completion of the reaction, the solvent was distilled under reduced pressure and separated by column chromatography to obtain 75 g of squarylium dye 5 below.

### <Squarylium dye 5>

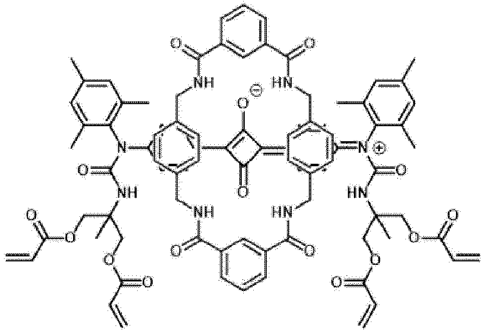

### Synthesis Example 6 (Synthesis of Squaryllium dyes 6 and 7)

### Synthesis Example 6-1

Synthesis was performed in the same manner as in Synthesis Example 1-1 except for using 92 g (476.4 mmol) of 1-bromo-2-ethylhexane (Sigma Aldrich) instead of 86 g (475 mmol) of 6-bromo-1-hexanol (TCI Co.). Through this, it was possible to obtain 130 g of an intermediate product such as Compound I-1.

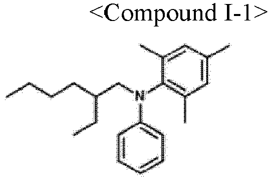

### Synthesis Example 6-2

Synthesis was performed in the same manner as in Synthesis Example 1-2 except for using 129 g (398.7 mmol) of Compound I-1 instead of 125 g (401.3 mmol) of Compound D-1. Through this, it was possible to obtain 128 g of squarylium dye 6.

### <Squarylium dye 6>

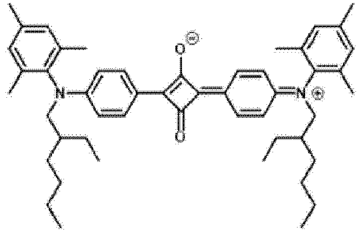

### Synthesis Example 6-3

After dissolving 73 g (100.7 mmol) of squarylium dye 6 of Synthesis Example 6-2 in 300 g of chloroform (Sigma Aldrich) at room temperature, 61g (300.5 mmol) of isophthaloyl chloride (Sigma Aldrich) and 41 g (301.1 mmol) of *p*-xylylenediamine (Sigma Aldrich) Company) were added dropwise over 3 hours and stirred for 18 hours. After completion of the reaction, the solvent was distilled under reduced pressure and separated by column chromatography to obtain 110 g of squarylium dye 7 below.

### <Squarylium dye 7>

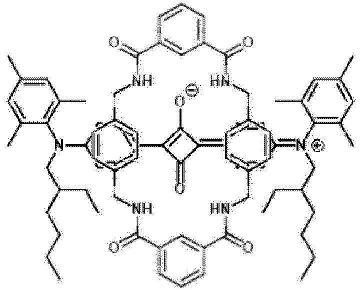

### Synthesis Example 7 (Synthesis of Squaryllium dye 8)

### Synthesis Example 7-1

Synthesis was performed in the same manner as in Synthesis Example 1-3 except for using 28 g (198.4 mmol) of 2-isocyanatoethyl acrylate (TCI Co.) was used instead of 48 g (200.7mmol) of Karenz BEI (Showa Denko Co.). Through this, it was possible to obtain 80 g of squarylium dye 8.

### <Squarylium dye 8>

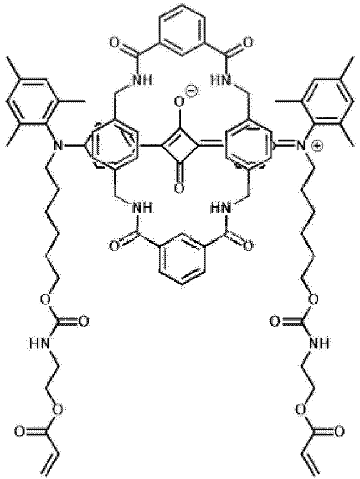

### [Synthesis of alkali-soluble resin (Binder)]

### Synthesis Example 8 (Synthesis of Binder 1-1 to Binder 1-7)

### Synthesis Example 8-1

### (Preparation of Compound 1-1)

80 g (0.228 mol) of 9,9'-bisphenol fluorene (Sigma Aldrich), 42.67 g (0.461 mol) of glycidyl chloride (Sigma Aldrich), and 191 g (1.38 mol) of anhydrous potassium carbonate with 600 mL of dimethylformamide were added into a 1,500 mL 3-neck round-bottom flask equipped with a distillation tube, the temperature was raised to 80°C and reacted for 4 hours. Then, the temperature was lowered to 25°C and the reaction solution was filtered and the filtrate was added dropwise to 1,000 mL of water while stirring, and the precipitated powder was filtered, washed with water, and dried at 40°C under reduced pressure to obtain 100 g (216 mmol) of Compound 1-1. The obtained powder showed a purity of 98% as a result of purity analysis by HPLC.

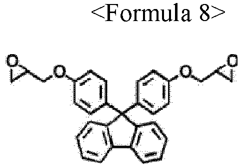

### Synthesis Example 8-2

### (Preparation of Monomer 1-1 to Monomer 1-3)

25g (54 mmol) of Compound 1-1 obtained in Synthesis Example 8-1, 7.9 g (0.11 mol) g of acrylic acid (Daejung Chemicals & Metals), 0.03 g (0.16 mmol) of benzyltriethylammonium chloride (Daejung Chemicals & Metals), 0.01 g (0.05 mmol) of hydroquinone (Daejung Chemicals & Metals), and 52 g of toluene (Sigma Aldrich) were added into a 300 mL 3-neck round-bottom flask equipped with a distillation tube, and the mixture was stirred at 110°C for 6 hours. After completion of the reaction, toluene was removed by distillation under reduced pressure to obtain a product. After filling 500 g of silica gel 60 (230-400 mesh, Merck) into a glass column with a diameter of 220 mm, 20 g of the product was loaded thereinto, and separation was performed using 10 L of a solvent, in which hexane and ethyl acetate were mixed at a 4: 1 volume ratio to thereby separate Monomer 1-1 to Monomer 1-3.

### <Monomer 1-1>

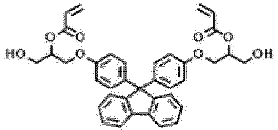

### <Monomer 1-2>

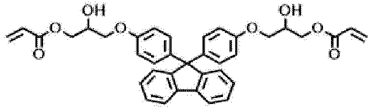

### <Monomer 1-3>

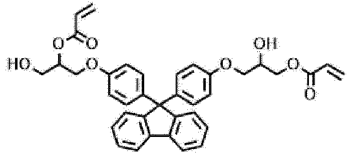

### Synthesis Example 8-3 to Synthesis Example 8-9

### (Preparation of Binder 1-1 to Binder 1-7)

Monomer 1-1, Monomer 1-2, and Monomer 1-3 obtained in Synthesis Example 8-2 were added into a 50 mL 3-necked round bottom flask equipped with a distillation tube below so that the sum of 5 g (8.2 mmol) as shown in Table 1, 0.005 g (0.03mmol) of benzyltriethyl ammonium chloride (Daejung Chemicals & Metals), 0.001 g (0.01 mmol) of hydroquinone (Daejung Chemicals & Metals), and 14 g of propylene glycol methyl ether acetate (Sigma Aldrich) into a 3-neck round-bottom flask equipped with a distillation tube, and then, 1.21 g (4 mmol) of biphenyltetracarboxylic dianhydride (Mitsubishi Gas) and 0.38 g (2 mmol) of tetrahydrophthalic acid (Sigma Aldrich) were added and stirred at 110°C for 6 hours. After completion of the reaction, the reaction solution was recovered to obtain Binder 1-1 to Binder 1-7, in which the repeating units of Monomers 1-1, 1-2, and 1-3 were mixed, in the form of a solution having a solid content of 45%. The synthesized polymers were analyzed for molecular weight using gel permeation chromatography (Agilent).

**[Table 1]**

| | Synthesis Example 8-3 (Binder 1-1) | Synthesis Example 8-4 (Binder 1-2) | Synthesis Example 8-5 (Binder 1-3) | Synthesis Example 8-6 (Binder 1-4) | Synthesis Example 8-7 (Binder 1-5) | Synthesis Example 8-8 (Binder 1-6) | Synthesis Example 8-9 (Binder 1-7) |
|---|---|---|---|---|---|---|---|
| Monomer 1-1 | 3 g (4.95 mmol) | 1 g (1.65 mmol) | 1 g (1.65 mmol) | 4.25 g (7.01 mmol) | 0.25 g (0.41 mmol) | 5 g (8.24 mmol) | 0g |
| Monomer 1-2 | 1 g (1.65 mmol) | 3g (4.95 mmol) | 1 g (1.65 mmol) | 0.25 g (0.41 mmol) | 4.25 g (7.01 mmol) | 0 g | 5g (8.24 mmol) |
| Monomer 1-3 | 1 g (1.65 mmol) | 1 g (1.65 mmol) | 3g (4.95 mmol) | 0.5 g (0.83 mmol) | 0.5 g (0.83 mmol) | 0 g | 0g |
| Weight Average | 4,800 g/mol | 4,200 g/mol | 4,600 g/mol | 4,400 g/mol | 4,100 g/mol | 5,200 g/mol | 3,300 g/mol |
| Molecular Weight | | | | | | | |

### Synthesis Example 9 (Synthesis of Acryl Binder)

55 g (416.2 mmol) of propylene glycol methyether acetate (Sigma Aldrich), 31.5 g (178.8 mmol) of benzyl methacrylate (Sigma Aldrich), 2.25 g (0.01 mol) of azobisisobutyronitrile (Sigma Aldrich), 6.75 g (0.07 mol) of methyl methacrylate (Sigma Aldrich), and 6.75g (0.08 mol) of methacrylic acid (Sigma Aldrich) were added into a 3-neck round-bottom flask equipped with a distillation tube, and the mixture was stirred at 80°C for 3 hours to obtain a propylene glycol methyether acetate solution containing 30 wt% solids of acryl binder (Mw: 10,000).

### Preparation Example 1 (Preparation of Green Pigment Dispersion

16 g of FASTOGEN^{®} GREEN A350 (green pigment/DIC), 6 g of Disperbyk 163 (BYK), and 3 g of SR-6100 (SMS), 70 g of propylene glycol methyl ether acetate, and 100 g of zirconia beads (diameter: 0.5 mm, Toray) were dispersed for 10 hours using a paint shaker (Asada) to obtain a dispersion.

### Preparation Example 2 (Preparation of compositions including alkali-soluble resin of the present disclosure)

Composition 1-1 to Composition 1-5, which include the chromophore-protecting dye of the present disclosure and the alkali-soluble resin of the present disclosure; and Composition 1-6 to Composition 1-9, which include a dye different from the chromophore-protecting dye of the present disclosure and the alkali-soluble resin of the present disclosure were prepared in accordance with the compositions (wt%) as shown in Table 2 below.

Before preparing the photosensitive resin compositions as follows, squarylium dyes 1 to 8 obtained in Synthesis Example 1 to Synthesis Example 7 were dissolved to a concentration of 16 wt% in a propylene glycol methyl ether acetate solvent.

**[Table 2]**

| | Preparat ion Exampl e 2-1 (Compo sition 1-1) | Preparat ion Exampl e 2-2 (Compo sition 1-2) | Preparat ion Exampl e 2-3 (Compo sition 1-3) | Preparat ion Exampl e 2-4 (Compo sition 1-4) | Preparat ion Exampl e 2-5 (Compo sition 1-5) | Preparat ion Exampl e 2-6 (Compo sition 1-6) | Preparat ion Exampl e 2-7 (Compo sition 1-7) | Preparat ion Exampl e 2-8 (Compo sition 1-8) | Preparat ion Exampl e 2-9 (Compo sition 1-9) |
|---|---|---|---|---|---|---|---|---|---|
| Squarylium dye 1 Solution | 30 | - | - | - | - | - | - | - | - |
| Squarylium dye 2 Solution | - | 30 | - | - | - | - | | - | - |
| Squarylium dye 3 Solution | - | - | 30 | - | - | - | - | - | - |
| Squarylium dye 4 Solution | - | - | - | 30 | - | - | - | - | - |
| Squarylium dye 5 Solution | - | - | - | - | 30 | - | - | - | - |
| Squarylium dye 6 Solution | - | - | - | - | - | 30 | - | - | - |
| Squarylium dye 7 Solution | - | - | - | - | - | - | 30 | - | - |
| Squarylium dye 8 | - | - | - | - | - | - | - | 30 | - |
| Solution | | | | | | | | | |
| Green Pigment Dispersion | - | - | - | - | - | - | - | - | 30 |
| OXE-02 (BASF) | 0.5 | 0.5 | 0.5 | 0.5 | 0.5 | 0.5 | 0.5 | 0.5 | 0.5 |
| M600 (Miwon Specialty Chemical) | 5 | 5 | 5 | 5 | 5 | 5 | 5 | 5 | 5 |
| Binder 1-1 | 9 | - | - | 9 | - | 9 | - | - | 9 |
| Binder 1-2 | - | 9 | - | - | 9 | - | 9 | - | - |
| Binder 1-3 | - | - | 9 | - | - | - | - | 9 | - |
| Propylene Glycol Methyl Ether Acetate (Daicel) | 55.5 | 55.5 | 55.5 | 55.5 | 55.5 | 55.5 | 55.5 | 55.5 | 55.5 |

### Preparation Example 3 (Preparation of compositions not including alkali-soluble resin of the present disclosure)

Composition 2-1 to Composition 2-5, which include an alkali-soluble resin different from the alkali-soluble resin of the present disclosure and a chromophore-protecting group dye of the present disclosure; and Composition 2-6 to Composition 2-9, which include a dye different from the chromophore-protecting dye of the present disclosure and the alkali-soluble resin different from the present disclosure were prepared in accordance with the compositions (wt%) as shown in Table 3 below.

Before preparing the photosensitive resin compositions as follows, squarylium dyes 1 to 8 obtained in Synthesis Example 1 to Synthesis Example 7 were dissolved to a concentration of 16 wt% in a propylene glycol methyl ether acetate solvent.

**[Table 3]**

| | Preparat ion Exampl e 3-1 (Compo sition 2-1) | Preparat ion Exampl e 3-2 (Compo sition 2-2) | Preparat ion Exampl e 3-3 (Compo sition 2-3) | Preparat ion Exampl e 3-4 (Compo sition 2-4) | Preparat ion Exampl e 3-5 (Compo sition 2-5) | Preparat ion Exampl e 3-6 (Compo sition 2-6) | Preparat ion Exampl e 3-7 (Compo sition 2-7) | Preparat ion Exampl e 3-8 (Compo sition 2-8) | Preparat ion Exampl e 3-9 (Compo sition 2-9) |
|---|---|---|---|---|---|---|---|---|---|
| Squarylium dye 1 Solution | 30 | - | - | - | - | - | - | - | - |
| Squarylium dye 2 Solution | - | 30 | - | - | - | - | | - | - |
| Squarylium dye 3 Solution | - | - | 30 | - | - | - | - | - | - |
| Squarylium dye 4 Solution | - | - | - | 30 | - | - | - | - | - |
| Squarylium dye 5 Solution | - | - | - | - | 30 | - | - | - | - |
| Squarylium dye 6 Solution | - | - | - | - | - | 30 | - | - | - |
| Squarylium dye 7 Solution | - | - | - | - | - | - | 30 | - | - |
| Squarylium dye 8 Solution | - | - | - | - | - | - | - | 30 | - |
| Green Pigment Dispersion | - | - | - | - | - | - | - | - | 30 |
| OXE-02 (BASF) | 0.5 | 0.5 | 0.5 | 0.5 | 0.5 | 0.5 | 0.5 | 0.5 | 0.5 |
| M600 (Miwon Specialty Chemical) | 5 | 5 | 5 | 5 | 5 | 5 | 5 | 5 | 5 |
| Binder 1-6 | 9 | - | - | 9 | - | 9 | - | - | 9 |
| Binder 1-7 | - | 9 | - | - | 9 | - | 9 | - | - |
| Acryl Binder | - | - | 9 | - | - | - | - | 9 | - |
| Propylene Glycol Methyl Ether Acetate (Daicel) | 55.5 | 55.5 | 55.5 | 55.5 | 55.5 | 55.5 | 55.5 | 55.5 | 55.5 |

The methods for preparing a film using the composition solutions prepared in accordance with Table 2 and Table 3 above are as follows (a photolithography step).

### (1) Application and coating steps

The photosensitive compositions of Table 2 and Table 3 above are each applied to a 10 cm* 10 cm SiNx substrate using a spin coater to a thickness of 2.5 µm, and then a coating film is formed by removing the solvent by heating at the temperature of 90°C for 1 minute.

### (2) Exposure to light step

After an open mask of a predetermined shape was interposed in order to form a pattern necessary for the coating films obtained above, and actinic rays of 190 nm to 500 nm were irradiated. MA-6 was used as an exposure apparatus and an exposure amount of 50 mJ/cm² was irradiated.

### (3) Developing step

Following the exposure step, the resultant was developed by the dipping method in a 0.04 wt% aqueous solution of KOH at 25°C for 1 minute, and then washed with water.

### (4) Post-baking step

After the films obtained by the development were each subjected to post-baking treatment in an oven at 90°C for 60 minutes, films formed of the compositions in accordance with Tables 2 and 3 were obtained.

### Example (evaluation of light resistance and chemical resistance of films)

The light resistance and chemical resistance of the films of the compositions in accordance with Tables 2 and 3 prepared by the photolithography step were evaluated by the following methods.

### [Example 1]

After evaluating the light resistance and chemical resistance of the films formed of the composition 1-1 by the following methods, the results are shown in Table 4 below.

### 1. Light fastness evaluation (ΔEab* measurement)

Eab* was measured by MCPD (Otsuka Co.) before and after the process of 100 hours in a Q-SUN XE-1 (Q-LAB Co.) light resistance tester of the film of composition 1-1 in Table 2 prepared by the photolithography step, respectively, and the amount of change is shown in Table 4 below.

### 2. Chemical resistance evaluation (measurement of change in transmittance before and after immersion into solvent)

After measuring the transmittance of the film of the composition 1-1 obtained through the photolithography step with UV-2600 (Shimadzu Co.), the film was placed in propylglen glycol methyl ether acetate at 50°C for 5 minutes, and then the transmittance of the film was measured. The chemical resistance was measured by measuring and observing the change in thickness. The transmittance measurement wavelength and the measurement results are as shown in Table 6 below.

### [Example 2 to Example 5]

A film was formed in the same manner as in Example 1 using Composition 1-2 to Composition 1-5 instead of Composition 1-1 in Example 1. After evaluating the light resistance and chemical resistance of the formed films in the same manner as in Example 1, the results are shown in Table 4 and Table 6.

### [Comparative Example 1 to Comparative Example 4]

Films were formed in the same manner as in Example 1 using Composition 1-6 to Composition 1-9 instead of Composition 1-1 in Example 1. After evaluating the light resistance and chemical resistance of the formed films in the same manner as in Example 1, the results are shown in Table 4 and Table 6.

### [Example 6 to Example 10]

Films were formed in the same manner as in Example 1 using Composition 2-2 to Composition 2-5 instead of Composition 1-1 in Example 1. After evaluating the light resistance and chemical resistance of the formed film in the same manner as in Example 1, the results are shown in Table 5 and Table 6.

### [Comparative Example 5 to Comparative Example 8]

Films were formed in the same manner as in Example 1 using Composition 2-6 to Composition 2-9 instead of Composition 1-1 in Example 1. After evaluating the light resistance and chemical resistance of the formed film in the same manner as in Example 1, the results are shown in Table 5 and Table 6.

**[Table 4]**

| | Exampl e 1 | Exampl e2 | Exampl e3 | Exampl e 4 | Exampl e 5 | Compa rative Exampl e 1 | Compa rative Exampl e2 | Compa rative Exampl e 3 | Compa rative Exampl e 4 |
|---|---|---|---|---|---|---|---|---|---|
| Film Composition | Compo sition 1-1 | Compo sition 1-2 | Compo sition 1-3 | Compo sition 1-4 | Compo sition 1-5 | Compo sition 1-6 | Compo sition 1-7 | Compo sition 1-8 | Compo sition 1-9 |
| Change in Optical Properties Before and After Light Resistance Test (ΔEab *) | 3.01 | 3.05 | 2.78 | 2.69 | 2.72 | 11.25 | 3.75 | 3.57 | 9.78 |

**[Table 5]**

| | Exampl e 6 | Exampl e 7 | Exampl e 8 | Exampl e 9 | Exampl e 10 | Compa rative Exampl e 5 | Compa rative Exampl e 6 | Compa rative Exampl e 7 | Compa rative Exampl e 8 |
|---|---|---|---|---|---|---|---|---|---|
| Film Composition | Compo sition 2-1 | Compo sition 2-2 | Compo sition 2-3 | Compo sition 2-4 | Compo sition 2-5 | Compo sition 2-6 | Compo sition 2-7 | Compo sition 2-8 | Compo sition 2-9 |
| Change in Optical Properties Before and After Light Resistance Test (ΔEab *) | 3.24 | 3.21 | 2.97 | 2.94 | 2.99 | 15.46 | 4.01 | 3.81 | 11.24 |

**[Table 6]**

| | Film Composi tion | Transmittance by Wavelength Before Immersion in Solvent (%) | | | Transmittance by Wavelength After Immersion in Solvent (%) (propylene glycol methyl ether acetate, 50°C, 5 min) | | | Difference in Transmittance by Wavelength Before and After Immersion in Solvent (%) | | |
|---|---|---|---|---|---|---|---|---|---|---|
| 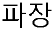 (nm) | - | 450 | 530 | 620 | 450 | 530 | 620 | 450 | 530 | 620 |
| Example 1 | Composi tion 1-1 | 0.08 | 82.1 | 0.09 | 0.13 | 83.3 | 0.16 | 0.05 | 1.2 | 0.07 |
| Example 2 | Composi tion 1-2 | 0.07 | 80.2 | 0.04 | 0.12 | 81.9 | 0.14 | 0.05 | 1.7 | 0.1 |
| Example 3 | Composi tion 1-3 | 0.06 | 80.7 | 0.04 | 0.14 | 81.7 | 0.16 | 0.08 | 1 | 0.12 |
| Example 4 | Composi tion 1-4 | 0.06 | 81.1 | 0.05 | 0.11 | 82.6 | 0.09 | 0.05 | 1.5 | 0.04 |
| Example 5 | Composi tion 1-5 | 0.03 | 81.1 | 0.03 | 0.09 | 81.4 | 0.06 | 0.06 | 0.3 | 0.03 |
| Example 6 | Composi tion 2-1 | 0.11 | 82.8 | 0.14 | 0.18 | 84.2 | 0.24 | 0.07 | 1.4 | 0.1 |
| Example 7 | Composi tion 2-2 | 0.09 | 81.1 | 0.07 | 0.18 | 83.2 | 0.21 | 0.09 | 2.1 | 0.14 |
| Example 8 | Composi tion 2-3 | 0.07 | 81.1 | 0.04 | 0.18 | 82.4 | 0.25 | 0.11 | 1.3 | 0.21 |
| Example 9 | Composi tion 2-4 | 0.07 | 80.9 | 0.04 | 0.18 | 82.6 | 0.13 | 0.11 | 1.7 | 0.09 |
| Example 10 | Composi tion 2-5 | 0.05 | 81.3 | 0.05 | 0.16 | 83.1 | 0.27 | 0.11 | 1.8 | 0.22 |
| Comparativ e Example 1 | Composi tion 1-6 | 0.02 | 79.8 | 0.03 | 10.75 | 93.6 | 12.8 | 10.73 | 13.8 | 12.77 |
| Comparativ e Example 2 | Composi tion 1-7 | 0.03 | 80.3 | 0.03 | 8.97 | 91.8 | 10.1 | 8.94 | 11.5 | 10.07 |
| Comparativ e Example 3 | Composi tion 1-8 | 0.06 | 81.8 | 0.05 | 4.11 | 86.5 | 5.04 | 4.05 | 4.7 | 4.99 |
| Comparativ e Example 4 | Composi tion 1-9 | 0.37 | 71.6 | 0.52 | 0.52 | 71.9 | 0.59 | 0.15 | 0.3 | 0.07 |
| Comparativ e Example 5 | Composi tion 2-6 | 0.04 | 80.1 | 0.04 | 11.45 | 95.45 | 13.49 | 11.41 | 15.35 | 13.45 |
| Comparativ | Composi | 0.05 | 80.7 | 0.05 | 9.3 | 94.23 | 11.29 | 9.25 | 13.53 | 11.24 |
| e Example 6 | tion 2-7 | | | | | | | | | |
| Comparativ e Example 7 | Composi tion 2-8 | 0.09 | 82.1 | 0.07 | 5.05 | 88.22 | 6.5 | 4.96 | 6.12 | 6.43 |
| Comparativ e Example 8 | Composi tion 2-9 | 0.41 | 72.1 | 0.75 | 0.67 | 72.61 | 0.9 | 0.26 | 0.51 | 0.15 |

It can be seen from Table 4 that the films of Example 1 to Example 5, which include the chromophore-protecting dye of the present disclosure and the alkali-soluble resin of the present disclosure, showed an improvement in light resistance compared to the films of Comparative Example 1 to Comparative Example4, which include the alkali-soluble resin of the present disclosure but do not include the chromophore-protecting group dye of the present disclosure.

Additionally, it can be seen from Table 5 that the films of Example 6 to Example 10, which include the chromophore-protecting dye of the present disclosure, showed excellent light resistance compared to the films of Comparative Example 5 to Comparative Example 8, which do not include the chromophore-protecting group dye of the present disclosure.

It can be seen from Table 6 that the films of Example 1 to Example 10, which include the chromophore-protecting dye of the present disclosure, the difference in transmittance was decreased compared to the films of Comparative Example 5 to Comparative Example 8, which do not include the chromophore-protecting group dye of the present disclosure, and accordingly, it can be seen that the films of Example 1 to Example 10, which include the chromophore-protecting dye of the present disclosure, showed an improvement in chemical resistance compared to the films of Comparative Example 5 to Comparative Example 8, which do not include the chromophore-protecting group dye of the present disclosure.

The present disclosure is not limited to the above embodiments, but can be prepared in a variety of different ways.

The above description is merely illustrative of the present disclosure, and those skilled in the art will be able to make various modifications without departing from the essential characteristics of the present disclosure.

Accordingly, the embodiments disclosed herein are illustrative and not intended to limit the invention, and the spirit and scope of the present disclosure are not limited by these embodiments. The protection scope of the present disclosure should be construed according to the claims, and all techniques within the equivalent range should be construed as being included in the scope of the present disclosure.

### [Code Explanation]

| | | | |
|---|---|---|---|
| 1: | substrate | 2: | TFT layer |
| 3: | flattening layer | 4 : | pixel electrode |
| 5: | pixel defining layer | 6: | organic material layer |
| 7: | counter electrode | 8: | sealing layer |
| 9: | touch panel | 10: | color unit |
| 11: | color separation unit | | |

## Claims

1. A reactive dye, comprising:
a chromophore comprising a structure represented by Formula (1); and a protecting group comprising a structure represented by Formula (2) and surrounding the chromophore; 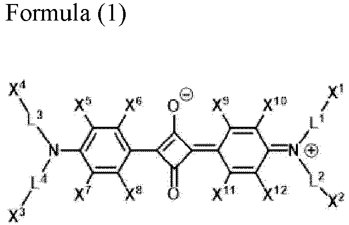
wherein in Formula (1) above,
1) L¹ to L⁴ are each independently a single bond; a fluorenylene group; C₁₋₃₀ alkylene; a C₃₋₃₀ cycloalkylene group; a C₁₋₃₀ alkoxylene group, a C₂₋₃₀ polyethyleneoxy group; a C₆₋₃₀ arylene group; a C₂₋₃₀ heterocyclic ring; or a combination thereof,
2) X¹ to X⁴ are each independently hydrogen; deuterium; a fluorenyl group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or Formula (A),
3) at least one of X¹ to X⁴ is Formula (A), 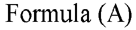 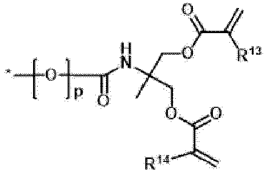 in Formula (A) above,
3-1) * is a moiety bonded to L¹ to L⁴ or N,
3-2) p is an integer from 0 to 1,
3-3) when Formula (A) is directly bonded to N, p is 0,
3-4) R¹³ and R¹⁴ are independently hydrogen or a methyl group,
4) X⁵ to X¹² are each independently hydrogen; deuterium; a fluorenyl group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or a C₁₋₃₀ alkylamine group,
5) X⁵ to X¹² are able to bind to each other to form a ring, 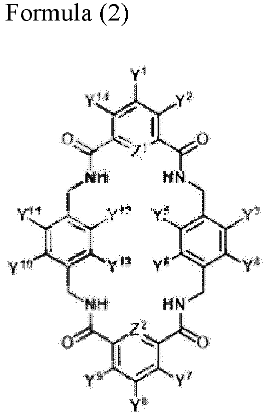 wherein in Formula (2) above,
6) Z¹ and Z² are each independently a carbon atom or a nitrogen atom,
7) Y¹ to Y¹⁴ are each independently hydrogen; deuterium; halogen; a fluorenyl group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; or a C₁₋₃₀ alkylamine group,
8) Y¹ to Y¹⁴ are able to bind to each other to form a ring,
9) the X¹ to X¹⁴, Y¹ to X¹⁴, and L¹ to L⁴ may each be further substituted with one or more substituents selected from the group consisting of deuterium; halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C₆₋₃₀ aryl group; a C₆₋₃₀ aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or may form a ring between the neighboring substituents.

2. The reactive dye of claim 1, wherein at least one of X¹ and X² Formula (A), and at least one of X³ and X⁴ Formula (A).

3. The reactive dye of claim 2, wherein among the X¹ to X⁴, the remainder where Formula (A) is not substituted are each independently a C₆₋₃₀ aryl group; a C₁₋₃₀ alkyl group; or a C₃-₃₀ cycloalkyl group.

4. The reactive dye of claim 2, wherein among the X¹ to X⁴, the remainder where Formula (A) is not substituted is a C₆₋₃₀ aryl group, which is further substituted a C₁₋₃₀ alkyl group.

5. The reactive dye of claim 1, wherein the chromophore comprising the structure represented by Formula (1) has a maximum absorption peak at a wavelength of 520 nm to 680 nm.

6. The reactive dye of claim 1, wherein the cage width of the protecting group comprising the structure represented by Formula (2) is 6.5 Å to 7.5 Å, and the volume of the protecting group is 10 Å to 16 Å.

7. The reactive dye of claim 1, which comprises a chromophore comprising a structure represented by Formula (1) and a protecting group comprising a structure represented by Formula (2) in a 1:1 molar ratio.

8. A photosensitive composition comprising an alkali-soluble resin; a reactive unsaturated compound; a photoinitiator; the reactive dye of claim 1; and a solvent.

9. The photosensitive composition of claim 8, wherein the dye is comprised in an amount of 0.1 wt% to 50 wt% based on the solid content excluding the solvent.

10. The photosensitive composition of claim 8, further comprising a colorant in the above components.

11. The photosensitive composition of claim 10, wherein the colorant comprises at least one of a dye and a pigment.

12. The photosensitive composition of claim 10, wherein the reactive dye and the colorant are comprised in a weight ratio of 1:9 to 9: 1.

13. The photosensitive composition of claim 10, wherein the reactive dye and the colorant together are comprised in an amount of 0.1 wt% to 50 wt% based on the solid content excluding the solvent.

14. The photosensitive composition of claim 8, further comprising quantum dots in addition to the above components.

15. The photosensitive composition of claim 14, wherein the reactive dye and the quantum dots are comprised in a weight ratio of 1:9 to 9: 1.

16. The photosensitive composition of claim 8, wherein the alkali-soluble resin is a resin comprising a repeating unit of Formula (3): 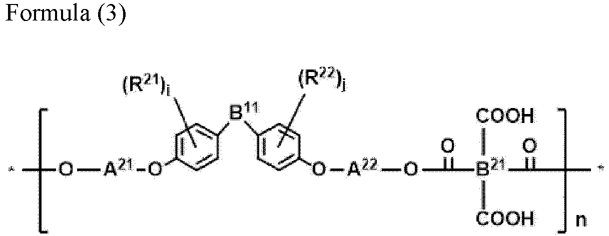 wherein in Formula (3) above,
1) * indicates a moiety where a bond is connected as a repeating unit,
2) n is a repeating unit of 2 to 200,000,
3) R²¹ and R²² are each independently hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a C₃₋₃₀ cycloalkyl group; a fluorenyl group; a carbonyl group; an ether group; or a C₁₋₃₀ alkoxycarbonyl group,
4) R²¹ and R²² may each form a ring with neighboring groups,
5) i and j are each independently an integer from 0 to 4,
6) B¹¹ is a single bond, O, CO, SO₂, CR'R", SiR'R", Formula (D), or Formula (E),
6-1) R' and R" are each independently hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁₋₃₀ alkoxycarbonyl group,
6-2) R' and R" may each form a ring with neighboring groups, 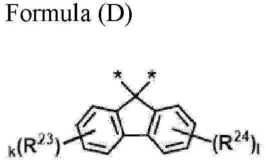 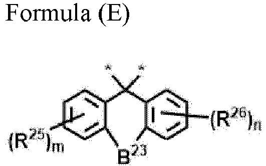 wherein in Formula (D) and Formula (E) above,
6-3) * indicates a binding position,
6-4) B²³ is O, S, SO₂, or NR',
6-5) R' is hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁₋₃₀ alkoxycarbonyl group,
6-6) R²³ to R²⁶ are each independently hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁₋₃₀ alkoxycarbonyl group,
6-7) R²³ to R²⁶ may each form a ring with neighboring groups,
6-8) k to n are each independently an integer from 0 to 4,
7) B²¹ is a fluorenyl group; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; or a combination thereof,
8) A²¹ and A²² are each independently Formula (F) or Formula (G), 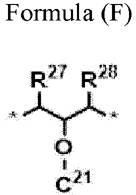 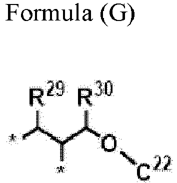 wherein in Formula (F) and Formula (G) above,
8-1) * indicates a binding position,
8-2) R²⁷ to R³⁰ are each independently hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a C₆₋₃₀ aryloxy group; a fluorenyl group; a carbonyl group; an ether group; or a C₁₋₃₀ alkoxycarbonyl group,
8-3) C²¹ and C²² are each independently Formula (H), 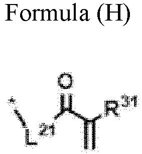
8-3-1) * indicates a binding position,
8-3-2) R³¹ is hydrogen; deuterium; halogen; a C₆₋₃₀ aryl group; a C₂₋₃₀ heterocyclic group comprising at least one heteroatom among O, N, S, Si, and P; a fused ring group of a C₆₋₃₀ aliphatic ring and a C₆₋₃₀ aromatic ring; a C₁₋₃₀ alkyl group; a C₂₋₃₀ alkenyl group; a C₂₋₃₀ alkynyl group; a C₁₋₃₀ alkoxy group; a fluorenyl group; a carbonyl group; an ether group; or a C₁₋₃₀ alkoxycarbonyl group,
8-3-3) L²¹ is a single bond; a fluorenylene group; C₁₋₃₀ alkylene; a C₆₋₃₀ arylene group; a C₂₋₃₀ heterocyclic ring; or C₁₋₃₀ alkoxylene,
8-4) the ratio of Formula (F) to Formula (G) in the resin comprising the repeating unit represented by Formula (3) is 1:9 to 9:1,
9) the R²¹ to R³¹, R', R", B²¹, and L²¹ and the ring formed between the neighboring substituents may each be further substituted with one or more substituents selected from the group consisting of deuterium; halogen; a silane group substituted or unsubstituted with a C₁₋₃₀ alkyl group or C₆₋₃₀ aryl group; a siloxane group; a boron group; a germanium group; a cyano group; an amino group; a nitro group; a C₁₋₃₀ alkylthio group; a C₁₋₃₀ alkoxy group; a C₆₋₃₀ arylalkoxy group; a C₁₋₃₀ alkyl group; a C₂₋₃₀ alkenyl group; a C₂₋₃₀ alkynyl group; a C6-30 aryl group; a C6-30 aryl group substituted with deuterium; a fluorenyl group; a C₂₋₃₀ heterocyclic group comprising at least one heteroatom among O, N, S, Si, and P; a C₃₋₃₀ alicyclic group; a C₇₋₃₀ arylalkyl group; a C₈₋₃₀ arylalkenyl group; and a combination thereof; or may form a ring between the neighboring substituents.

17. The photosensitive composition of claim 16, wherein the alkali-soluble resin has a weight average molecular weight of 1,000 g/mol to 100,000 g/mol.

18. The photosensitive composition of claim 16, wherein the resin comprising the repeating unit represented by Formula (3) is comprised in an amount of 1 wt% to 50 wt% based on the total weight of the photosensitive composition.

19. The photosensitive composition of claim 8, wherein the reactive unsaturated compound is comprised in an amount of 1 wt% to 50 wt% based on the total amount of the photosensitive resin composition.

20. The photosensitive composition of claim 8, wherein the initiator is comprised in an amount of 0.01 to 10 wt% based on the total amount of the photosensitive resin composition.

21. A pattern or film formed from the photosensitive composition according to claim 8.

22. The pattern or film of claim 21, wherein the difference in transmittance at 450 nm to 620 nm before and after being immersed in propylene glycol methyl ether acetate at 50°C for 5 minutes is 0.01% to 2.5%.

23. An organic light emitting display device comprising the pattern or film according to claim 21.

24. The organic light emitting display device of claim 23, wherein one or more of a flattening layer, an organic light emitting device layer, an encapsulation layer, a touch panel, and a color filter comprises the pattern or film.

25. An electronic device comprising the display device of claim 23 and a control unit for operating the display device.
